(19) **Europäisches Patentamt / European Patent Office / Office européen des brevets**

(11) **EP 4 033 545 B1**

(12) # EUROPEAN PATENT SPECIFICATION

(45) Date of publication and mention
of the grant of the patent:
**15.04.2026 Bulletin 2026/16**

(21) Application number: **20866681.8**

(22) Date of filing: **27.02.2020**

(51) International Patent Classification (IPC):
**H10H 20/813** *(2025.01)*    **H10H 20/84** *(2025.01)*
**H10H 29/30** *(2025.01)*

(52) Cooperative Patent Classification (CPC):
**H10H 20/8132; H10H 20/84; H10H 29/30;**
H10H 20/818; H10W 72/0198; H10W 90/00

(86) International application number:
**PCT/KR2020/002785**

(87) International publication number:
**WO 2021/054551 (25.03.2021 Gazette 2021/12)**

(54) **LIGHT-EMITTING DIODE AND DISPLAY DEVICE COMPRISING SAME**

LICHTEMITTIERENDE DIODE UND ANZEIGEVORRICHTUNG DAMIT

DIODE ÉLECTROLUMINESCENTE ET DISPOSITIF D'AFFICHAGE COMPRENANT CELLE-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.09.2019 KR 20190113759**

(43) Date of publication of application:
**27.07.2022 Bulletin 2022/30**

(73) Proprietor: **Samsung Display Co., Ltd.**
**Yongin-si, Gyeonggi-do 17113 (KR)**

(72) Inventors:
• **AN, Moon Jung**
**Hwaseong-si Gyeonggi-do 18476 (KR)**
• **JO, Sung Chan**
**Seoul 06586 (KR)**
• **PARK, Hoo Keun**
**Cheongju-si Chungcheongbuk-do 28165 (KR)**

• **YOO, Chul Jong**
**Seongnam-si Gyeonggi-do 13428 (KR)**
• **KANG, Hye Lim**
**Hwaseong-si Gyeonggi-do 18471 (KR)**
• **KIM, Dong Gyun**
**Seoul 03936 (KR)**
• **LEE, Dong Eon**
**Hwaseong-si Gyeonggi-do 18477 (KR)**
• **CHO, Hyun Min**
**Seoul 06802 (KR)**

(74) Representative: **Marks & Clerk LLP**
**15 Fetter Lane**
**London EC4A 1BW (GB)**

(56) References cited:
WO-A1-2015/005654     JP-A- 2011 205 060
KR-A- 20090 090 812     KR-A- 20180 007 376
KR-A- 20180 071 465     US-A1- 2018 175 106

# Description

[TECHNICAL FIELD]

The disclosure relates to a light emitting element and a display device including the same.

[BACKGROUND ART]

The importance of display devices has steadily increased with the development of multimedia technology. In response thereto, various types of display devices such as an organic light emitting display (OLED), a liquid crystal display (LCD) and the like have been used.

A display device is a device for displaying an image, and includes a display panel, such as an organic light emitting display panel or a liquid crystal display panel. The light emitting display panel may include light emitting elements, e.g., light emitting diodes (LED), and examples of the light emitting diode include an organic light emitting diode (OLED) using an organic material as a fluorescent material and an inorganic light emitting diode using an inorganic material as a fluorescent material.

Inorganic LEDs using an inorganic semiconductor as a fluorescent material are durable even in a high-temperature environment and have higher blue light efficiency than OLEDs. In addition, a transfer method using dielectrophoresis (DEP) has been developed for a manufacturing process which has been pointed out as a limitation of conventional inorganic LEDs. Therefore, research is being continuously conducted on inorganic LEDs having better durability and efficiency than OLEDs.

According to its abstract, US 2018/175106 A1 describes a light emitting device that includes: a substrate; a light emitting element on the substrate, the light emitting element having a first end portion and a second end portion arranged in a longitudinal direction; one or more partition walls disposed on the substrate, the one or more partition walls being spaced apart from the light emitting element; a first reflection electrode adjacent the first end portion of the light emitting element; a second reflection electrode adjacent the second end portion of the light emitting element; a first contact electrode connected to the first reflection electrode and the first end portion of the light emitting element; an insulating layer on the first contact electrode, the insulating layer having an opening exposing the second end portion of the light emitting element and the second reflection electrode to the outside; and a second contact electrode on the insulating layer.

[DISCLOSURE]

Aspects of the present invention are defined by the appended independent claims. Preferred embodiments of the present invention are defined by the appended dependent claims.

[Technical Problems]

Aspects of the disclosure provide a light emitting element including a thick electrode layer and a thick insulating film to protect an active layer.

Aspects of the disclosure also provide a display device including the light emitting element and having improved luminous reliability.

It should be noted that aspects of the disclosure are not limited thereto and other aspects, which are not mentioned herein, will be apparent to those of ordinary skill in the art from the following description.

[Technical Solutions]

According to an embodiment of the disclosure, a light emitting element comprises: a first semiconductor layer doped with a first polarity, a second semiconductor layer doped with a second polarity different from the first polarity, an active layer disposed between the first semiconductor layer and the second semiconductor layer, and an insulating film disposed to surround at least an outer surface of the active layer and extending in a first direction in which the first semiconductor layer, the active layer, and the second semiconductor layer are stacked, wherein a thickness of a first portion of the insulating film surrounding the active layer is in a range of 10% to 16% of a diameter of the active layer.

The diameter of the active layer may be in a range of 500 nm to 600 nm, and the thickness of the first portion of the insulating film may be in a range of 60 nm to 80 nm.

The insulating film may further include a second portion connected to the first portion and disposed to cover a partial region of a side surface of the second semiconductor layer, and a thickness of the second portion may be smaller than a thickness of the first portion.

In the insulating film, a portion surrounding an interface between the active layer and the second semiconductor layer may have a thickness of at least 20 nm.

The second portion may have a curved outer surface such that its thickness decreases in the first direction.

The light emitting element may further comprise an electrode layer disposed on the second semiconductor layer, wherein a thickness of the electrode layer may be greater than a thickness of the second semiconductor layer.

The electrode layer may have a thickness in a range of 20 nm to 200 nm.

The insulating film may be disposed to surround a side surface of the electrode layer.

The insulating film may be disposed to surround a part of a side surface of the electrode layer, and the electrode layer may have a top surface and a side surface partially exposed.

The insulating film may further include a third portion connected to the first portion and surrounding a partial region of the side surface of the electrode layer, and a thickness of the third portion may be smaller than a thickness of the first portion.

The third portion may have a curved outer surface such that its thickness decreases in the first direction.

According to an embodiment of the disclosure, a display device comprises: a substrate, a first electrode disposed on the substrate and a second electrode spaced apart from the first electrode, at least one light emitting element disposed between the first electrode and the second electrode and electrically connected to the first electrode and the second electrode, a first insulating layer disposed under the light emitting element between the first electrode and the second electrode, and a second insulating layer disposed on the light emitting element and exposing one end and the other end of the light emitting element, wherein the light emitting element includes: a first semiconductor layer doped with a first polarity, a second semiconductor layer doped with a second polarity different from the first polarity, an active layer disposed between the first semiconductor layer and the second semiconductor layer, and an insulating film disposed to surround at least an outer surface of the active layer and extending in a first direction in which the first semiconductor layer, the active layer, and the second semiconductor layer are stacked, wherein the insulating film includes a second portion in contact with the second insulating layer, a first portion surrounding one end of the light emitting element including the active layer, and a third portion surrounding the other end of the light emitting element, and a thickness of the second portion is greater than that of the first portion and the third portion.

The display device may further comprise a first contact electrode in contact with the first electrode and the one end of the light emitting element and a second contact electrode in contact with the second electrode and the other end of the light emitting element.

The light emitting element may further include an electrode layer disposed on the second semiconductor layer and having a thickness greater than that of the second semiconductor layer, the first contact electrode being in contact with the first portion of the insulating film and the electrode layer, the second contact electrode being in contact with the third portion of the insulating film and the first semiconductor layer.

The first portion of the insulating film may be disposed to surround a part of a side surface of the electrode layer, and the electrode layer may have a top surface and a side surface partially exposed.

The first contact electrode may be in contact with a part of a side surface and a top surface of the electrode layer.

The first portion of the insulating film may have a curved outer surface such that its thickness decreases in the first direction.

In the first portion, a first thickness measured at an interface between the second semiconductor layer and the electrode layer and a second thickness measured at an interface between the second semiconductor layer and the active layer may satisfy the following Eq. (1):

[Equation 1]

$$\theta c = \arctan((W2'-W1')/D) \leq 70°$$

where $\theta c$ is an inclination angle of an inclined outer surface of the first portion of the insulating film, W1' is a thickness measured at an interface between the electrode layer and the second semiconductor layer in the first portion of the insulating film, W2' is a thickness measured at an interface between the second semiconductor layer and the active layer in the first portion of the insulating film, and D is a thickness of the second semiconductor layer.

The second thickness may be 20 nm or more, and in the first portion, a thickness of a portion surrounding the active layer may be 40 nm or more.

The electrode layer may have a thickness in a range of 20 nm to 200 nm.

A thickness of the second portion may be in a range of 10% to 16% of a diameter of the active layer.

The diameter of the active layer may be in a range of 500 nm to 600 nm, and the thickness of the second portion of the insulating film may be in a range of 60 nm to 80 nm.

In the light emitting element, a first diameter measured at the second portion of the insulating film may be greater than a second diameter measured at the first portion of the insulating film and a third diameter measured at a third portion of the insulating film.

The details of other embodiments are included in the detailed description and the accompanying drawings.

[Advantageous Effects]

A light emitting element in accordance with one embodiment includes an electrode layer having a thickness greater than that of a second semiconductor layer, and an insulating film in which a portion surrounding the active layer has a thickness of a certain level or more. The light emitting element may prevent the electrode layer from being removed during a manufacturing process, and may safely protect the active layer even if the insulating film is partially etched.

Accordingly, the display device including the light emitting element may improve luminous efficiency and luminous reliability.

The effects according to the embodiments are not limited by the contents exemplified above, and more various effects are included in this disclosure.

[BRIEF DESCRIPTION OF DRAWINGS]

FIG. 1 is a schematic plan view of a display device according to one embodiment.

FIG. 2 is a schematic plan view of one pixel of a display device according to one embodiment.

FIG. 3 is a plan view illustrating one sub-pixel of FIG. 2.

FIG. 4 is a cross-sectional view taken along lines Xa-Xa', Xb-Xb' and Xc-Xc' of FIG. 3.

FIG. 5 is a schematic diagram of a light emitting element according to one embodiment.

FIG. 6 is a schematic cross-sectional view of a light emitting element according to one embodiment.

FIG. 7 is an enlarged view of part QA of FIG. 4.

FIG. 8 is a cross-sectional view illustrating a part of a display device according to one embodiment.

FIGS. 9 to 14 are cross-sectional views showing a manufacturing process of a light emitting element according to one embodiment.

FIGS. 15 to 19 are cross-sectional views illustrating a part of a manufacturing process of a display device according to one embodiment.

FIG. 20 is a schematic cross-sectional view of a light emitting element according to one embodiment.

FIG. 21 is a cross-sectional view partially illustrating a manufacturing process of the light emitting element of FIG. 20.

FIG. 22 is a cross-sectional view illustrating a part of the display device including the light emitting element of FIG. 20.

FIG. 23 is a schematic cross-sectional view of a light emitting element according to one embodiment.

FIG. 24 is a cross-sectional view illustrating a part of the display device including the light emitting element of FIG. 23.

FIG. 25 is a plan view illustrating one sub-pixel of a display device according to one embodiment.

FIG. 26 is a plan view illustrating one pixel of a display device according to one embodiment.

[BEST MODES FOR CARRYING OUT THE INVENTION]

The invention will now be described more fully hereinafter with reference to the accompanying drawings, in which preferred embodiments of the invention are shown. This invention may, however, be embodied in different forms and should not be construed as limited to the embodiments set forth herein.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

Hereinafter, embodiments will be described with reference to the accompanying drawings.

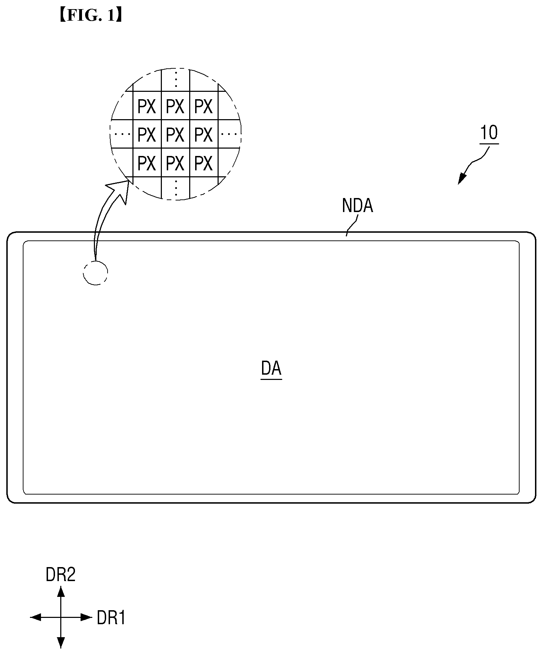

FIG. 1 is a schematic plan view of a display device according to one embodiment.

Referring to FIG. 1, a display device 10 displays a moving image or a still image. The display device 10 may refer to any electronic device providing a display screen. Examples of the display device 10 may include a television, a laptop computer, a monitor, a billboard, an Internet-of-Things device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game machine, a digital camera, a camcorder and the like, which provide a display screen.

The display device 10 includes a display panel which provides a display screen. Examples of the display panel may include an LED display panel, an organic light emitting display panel, a quantum dot light emitting display panel, a plasma display panel and a field emission display panel. In the following description, a case where an LED display panel is applied as a display panel will be exemplified, but the disclosure is not limited thereto, and other display panels may be applied within the same scope of technical idea.

The shape of the display device 10 may be variously modified. For example, the display device 10 may have a shape such as a rectangular shape elongated in a horizontal direction, a rectangular shape elongated in a vertical direction, a square shape, a quadrilateral shape with rounded corners (vertices), another polygonal shape and a circular shape. The shape of a display area DA of the display device 10 may also be similar to the overall shape of the display device 10. In FIG. 1, the display device 10 and the display area DA having a rectangular shape elongated in the horizontal direction are illustrated.

The display device 10 may include the display area DA and a non-display area NDA. The display area DA is an area where a screen can be displayed, and the non-display area NDA is an area where a screen is not displayed. The display area DA may also be referred to as an active region, and the non-display area NDA may also be referred to as a non-active region.

The display area DA may substantially occupy the center of the display device 10. The display area DA may include a plurality of pixels PX. The plurality of pixels PX may be arranged in a matrix. The shape of each pixel PX may be a rectangular or square shape in plan view. However, the disclosure is not limited thereto, and it may be a rhombic shape in which each side is inclined with respect to one direction. Each of the pixels PX may include one or more light emitting elements 300 that emit light of a specific wavelength band to display a specific color.

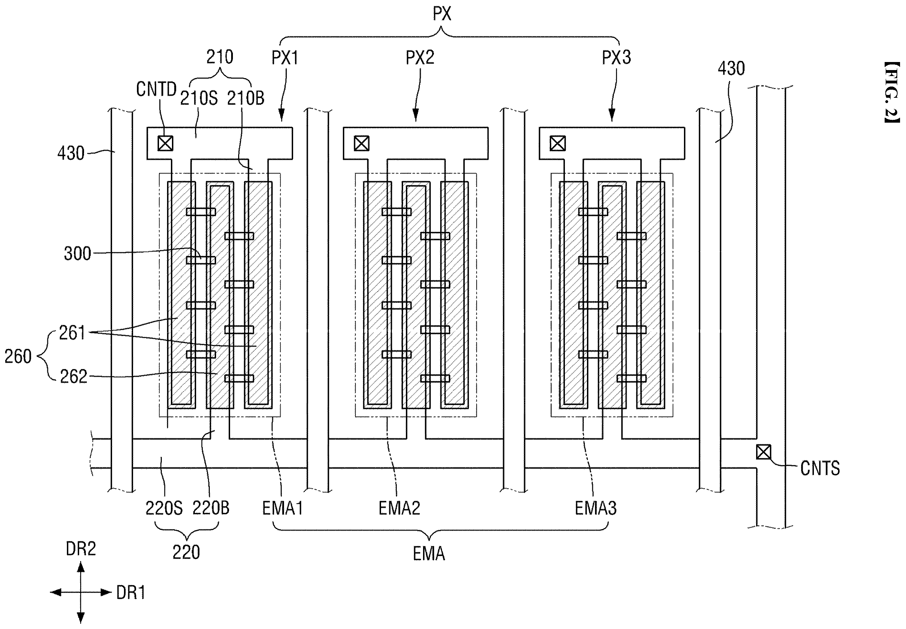

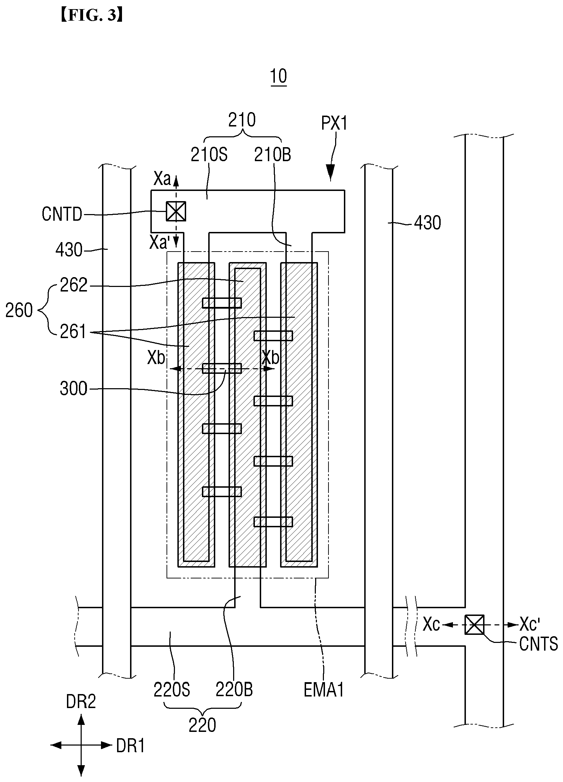

FIG. 2 is a schematic plan view of one pixel of a display device according to one embodiment. FIG. 3 is a plan view illustrating one sub-pixel of FIG. 2.

Referring to FIGS. 2 and 3, each of the pixels PX may include a first sub-pixel PX1, a second sub-pixel PX2, and a third sub-pixel PX3. The first sub-pixel PX1 may emit light of a first color, the second sub-pixel PX2 may emit light of a second color, and the third sub-pixel PX3 may emit light of a third color. The first color may be blue, the second color may be green, and the third color may be red. However, the disclosure is not limited thereto, and the sub-pixels PXn may emit light of the same color. In addition, although FIG. 2 illustrates that the pixel PX includes three sub-pixels PXn, the disclosure is not limited thereto, and the pixel PX may include a larger number of sub-pixels PXn.

Each sub-pixel PXn of the display device 10 may include a region defined as an emission area EMA. The first sub-pixel PX1 may include a first emission area EMA1, the second sub-pixel PX2 may include a second emission area EMA2, and the third sub-pixel PX3 may include a third emission area EMA2. The emission area EMA may be defined as a region where the light emitting elements 300 included in the display device 10 are disposed to emit light of a specific wavelength band. The light emitting element 300 includes the active layer 330, and the active layer 330 may emit light of a specific wavelength band without directionality. Lights emitted from the active layer 330 of the light emitting element 300 may be radiated in a lateral direction of the light emitting element 300 as well as in directions of both ends of the light emitting element 300. The emission area EMA of each sub-pixel PXn may include a region adjacent to the light emitting element 300 where the lights emitted from the light emitting element 300 are radiated, including the region where the light emitting element 300 is disposed. Further, without being limited thereto, the emission area EMA may also include a region where the light emitted from the light emitting element 300 is reflected or refracted by another member and emitted. The plurality of light emitting elements 300 may be disposed in the respective sub-pixels PXn, and the emission area EMA may be formed to include an area where the light emitting element 300 is disposed and an area adjacent thereto.

Although not illustrated in the drawing, each sub-pixel PXn of the display device 10 may include a non-emission area defined as a region other than the emission area EMA. The non-emission area may be a region in which the light emitting element 300 is not disposed and a region from which light is not emitted because light emitted from the light emitting element 300 does not reach it.

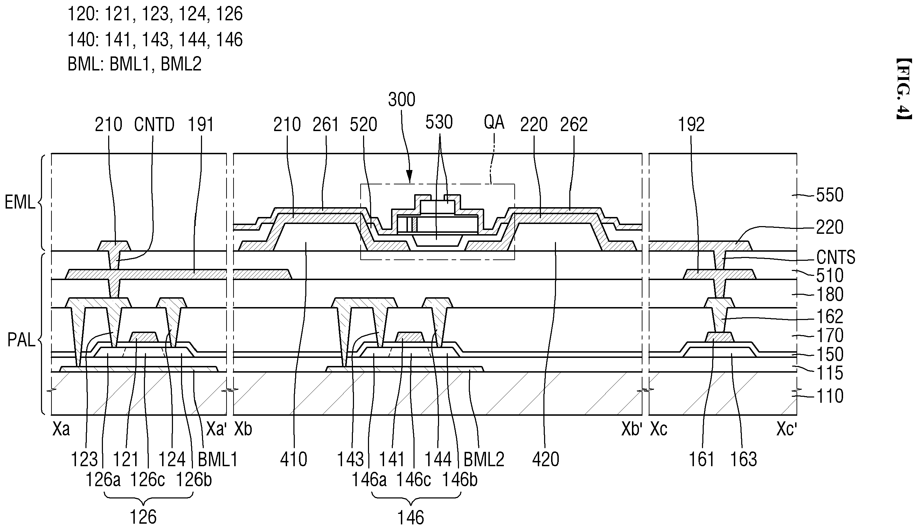

Each sub-pixel PXn of the display device 10 may include a plurality of electrodes 210 and 220, the light emitting element 300, a plurality of contact electrodes 260, and a plurality of external banks 430. Although not shown in FIGS. 2 and 3, the display device 10 may further include a plurality of internal banks 410 and 420 (see FIG. 4) and a plurality of insulating layers 510, 520, 530 and 550 (see FIG. 4).

The plurality of electrodes 210 and 220 may include a first electrode 210 and a second electrode 220. The first and second electrodes 210 and 220 may include respective electrode stems 210S and 220S arranged to extend in the first direction DR1 and at least one respective electrode branch 210B and 220B extending, in the second direction DR2 crossing the first direction DR1, from the respective electrode stems 210S and 220S.

The first electrode 210 may include the first electrode stem 210S extending in the first direction DR1, and at least one electrode branch 210B branched off from the first electrode stem 210S and extending in the second direction DR2.

The first electrode stems 210S of any one pixel may be arranged such that both ends of the individual first electrode stems 210S are terminated with gaps between the respective sub-pixels PXn, and each first electrode stem 210S may be arranged on substantially the same straight line as the first electrode stem 210S of the sub-pixel adjacent to it in the same row (for example, in the first direction DR1). Since the first electrode stems 210S disposed in the respective sub-pixels PXn are arranged such that both ends thereof are spaced apart from each other, it may be possible to apply different electric signals to the first electrode branches 210B.

The first electrode branch 210B may be branched off from at least a part of the first electrode stem 210S and extend in the second direction DR2, and may be terminated while being spaced apart from the second electrode stem 220S which is disposed to face the first electrode stem 210S.

The second electrode 220 may include the second electrode stem 220S extending in the first direction DR1 and disposed to face the first electrode stem 210S while being distanced apart from it in the second direction DR2; and the second electrode branch 220B branched off from the second electrode stem 220S and extending in the second direction DR2. The second electrode stem 220S may be connected at the other end to the second electrode stem 220S of another sub-pixel PXn adjacent to it in the first direction DR1. That is, unlike the first electrode stem 210S, the second electrode stem 220S may extend in the first direction DR1 across the respective sub-pixels PXn. The second electrode stem 220S that is elongated across the respective sub-pixels PXn may be connected to an outer part of the display area DA where the respective pixels PX or sub-pixels PXn are placed, or to an extension portion extended from the non-display area NDA in one direction.

The second electrode branch 220B may be disposed to face the first electrode branch 210B with a gap therebetween, and may be terminated while being spaced apart from the first electrode stem 210S. The second electrode branch 220B may be connected with the second electrode stem 220S, and an end of the second electrode branch 220B in the extension direction may be disposed within the sub-pixel PXn while being spaced apart from the first electrode stem 210S.

The first electrode 210 and the second electrode 220 may be electrically connected to the conductive layer of a circuit element layer PAL (see FIG. 4) of the display device 10 through contact holes, e.g., a first electrode contact hole CNTD and a second electrode contact hole CNTS, respectively. It is illustrated in the drawing that the first electrode contact hole CNTD is formed at every first electrode stem 210S of each sub-pixel PXn, whereas only one second electrode contact hole CNTS is formed at the single second electrode stem 220S which is elongated across the respective sub-pixels PXn. However, the disclosure is not limited thereto, and in some cases, even the second electrode contact hole CNTS may be formed for each sub-pixel PXn.

The electrodes 210 and 220 may be electrically connected with the light emitting elements 300, and may receive a preset voltage applied thereto to allow the light emitting elements 300 to emit light in a specific wavelength band. Further, at least a part of each of the electrodes 210 and 220 may be used to form an electric field within the sub-pixel PXn to align the light emitting elements 300.

In an embodiment, the first electrode 210 may be a pixel electrode which is separated for each sub-pixel PXn, and the second electrode 220 may be a common electrode connected along the respective sub-pixels PXn to be shared by them. One of the first and second electrodes 210 and 220 may be an anode electrode of the light emitting element 300 and the other may be a cathode electrode of the light emitting element 300. However, the disclosure is not limited thereto, and an opposite case may also be possible.

In the drawing, it is illustrated that two first electrode branches 210B are disposed in each sub-pixel PXn, and one second electrode branch 220B is disposed therebetween. However, the layout of the first and second electrode branches may not be limited thereto. In some cases, the first electrode 210 and the second electrode 220 may have a shape extending in the second direction DR2 without the electrode stems 210S and 220S. Further, the first and second electrodes 210 and 220 may not necessarily have the shape extending in one direction, and they may have various layouts. For example, the first electrode 210 and the second electrode 220 may have a partially curved or bent shape, and one electrode may be disposed to surround the other electrode. The layout and the shape of the first and second electrodes 210 and 220 may not be particularly limited as long as at least some portions thereof face each other with a gap therebetween, creating a space where the light emitting elements 300 may be disposed.

The external banks 430 may be disposed at the boundaries between the sub-pixels PXn. Each external bank 430 may extend in the second direction DR2 to be disposed at the boundary between the adjacent sub-pixels PXn which are arranged in the first direction DR1. The first electrode stems 210S may be terminated such that their respective ends are spaced apart from each other with the external banks 430 therebetween. However, the disclosure is not limited thereto, and the external bank 430 may extend in the first direction DR1 to be disposed at the boundary between the adjacent sub-pixels PXn which are arranged in the second direction DR2. The external banks 430 may include the same material as the internal banks 410 and 420 to be described later, and these external and internal banks may be formed simultaneously in one process.

The light emitting elements 300 may be disposed between the first electrode 210 and the second electrode 220. The light emitting element 300 may be electrically connected to the first electrode 210 at one end thereof and the second electrode 220 at the other end thereof. The light emitting element 300 may be electrically connected to each of the first electrode 210 and the second electrode 220 through the contact electrode 260.

The plurality of light emitting elements 300 may be spaced apart from each other and aligned substantially parallel to each other. The interval between the light emitting elements 300 is not particularly limited. In some cases, multiple light emitting elements 300 may be disposed adjacent to each other to form a group, and other multiple light emitting elements 300 may be arranged while being spaced apart from each other at a regular distance to form another group. That is, the light emitting elements 300 may be arranged in different densities but they may be still aligned in one direction. Further, in an embodiment, the light emitting element 300 may have a shape extending in one direction, and the extension direction of the electrodes, for example, the first electrode branch 210B and the second electrode branch 220B, may be substantially perpendicular to the extension direction of the light emitting element 300. However, the disclosure is not limited thereto, and the light emitting element 300 may be disposed diagonally with respect to the extension direction of the first electrode branch 210B and the second electrode branch 220B, not perpendicularly thereto.

The light emitting elements 300 according to one embodiment may have the active layers 330 including different materials, and thus may emit light of different wavelength bands to the outside. The display device 10 according to one embodiment may include the light emitting elements 300 that emit light of different wavelength bands. The light emitting element 300 of the first sub-pixel PX1 may include the active layer 330 that emits a first light L1 having a central wavelength band of a first wavelength, the light emitting element 300 of the second sub-pixel PX2 may include the active layer 330 that emits a second light L2 having a central wavelength band of a second wavelength, and the light emitting element 300 of the third sub-pixel PX3 may include the active layer 330 that emits a third light L3 having a central wavelength band of a third wavelength.

Accordingly, the first light L1 may be emitted from the first sub-pixel PX1, the second light L2 may be emitted from the second sub-pixel PX2, and the third light L3 may be emitted from the third sub-pixel PX3. In some embodiments, the first light L1 may be blue light having a central wavelength band of 450 nm to 495 nm, the second light L2 may be green light having a central wavelength band of 495 nm to 570 nm, and the third light L3 may be red light having a central wavelength band of 620 nm to 752 nm.

However, the disclosure is not limited thereto. In some cases, the first sub-pixel PX1, the second sub-pixel PX2, and the third sub-pixel PX3 may include the light emitting elements 300 of the same type to emit light of substantially the same color.

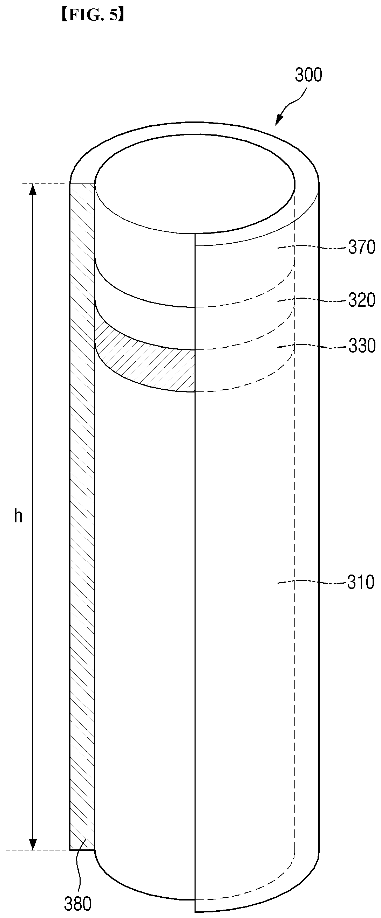

Meanwhile, the light emitting element 300 according to one embodiment may include a semiconductor core and an insulating film 380 (see FIG. 5) surrounding the semiconductor core. The semiconductor core may include a plurality of semiconductor layers 310 and 320 (see FIG. 5) and an active layer 330 (see FIG. 5) disposed therebetween. The light emitting element 300 may have one end electrically connected to the first electrode 210 and the other end electrically connected to the second electrode 220 to receive electric signals, and the light emitting element 300 that has received the electric signals may generate light in the active layer 330 and emit it to the outside. The insulating film 380 surrounding the semiconductor core of the light emitting element 300 may be disposed to surround at least the outer surface of the active layer 330 and protect it. The light emitting element 300 according to one embodiment may include the insulating film 380 having a thickness of a certain level or more, so that it is possible to prevent the active layer 330 of the light emitting element 300 from being damaged during the manufacturing process of the light emitting element 300 and the manufacturing process of the display device 10 and improve element reliability.

Further, the semiconductor core of the light emitting element 300 may further include an electrode layer 370 (see FIG. 5) disposed on the second semiconductor layer 320, and the light emitting element 300 may be electrically connected to the first electrode 210 or the second electrode 220 through the electrode layer 370. Here, the light emitting element 300 according to one embodiment may include the electrode layer 370 having a thickness of a certain level or more to prevent the electrode layer 370 of the light emitting element 300 from being removed during the manufacturing process of the light emitting element 300, thereby improving the element efficiency. A detailed description thereof will be given later with reference to other drawings.

The plurality of contact electrodes 260 may have a shape in which at least a partial region thereof extends in one direction. Each of the plurality of contact electrodes 260 may be in contact with the light emitting element 300 and the electrodes 210 and 220, and the light emitting elements 300 may receive the electrical signals from the first electrode 210 and the second electrode 220 through the contact electrode 260.

The contact electrode 260 may include a first contact electrode 261 and a second contact electrode 262. The first contact electrode 261 and the second contact electrode 262 may be disposed on the first electrode branch 210B and the second electrode branch 220B, respectively.

The first contact electrode 261 may be disposed on the first electrode 210 or the first electrode branch 210B, and may extend in the second direction DR2 to be in contact with one end of the light emitting element 300. The second contact electrode 262 may be spaced apart from the first contact electrode 261 in the first direction DR1, and may be disposed on the second electrode 220 or the second electrode branch 220B and extend in the second direction DR2 to be in contact with the other end of the light emitting element 300. The first contact electrode 261 and the second contact electrode 262 may be in contact with the first electrode 210 and the second electrode 220 exposed through the openings of the second insulating layer 520. The light emitting element 300 may be electrically connected to the first electrode 210 and the second electrode 220 through the first contact electrode 261 and the second contact electrode 262.

In some embodiments, the widths of the first contact electrode 261 and the second contact electrode 262 measured in one direction may be respectively greater than the widths of the first electrode 210 and the second electrode 220 or the widths of the first electrode branch 210B and the second electrode branch 220B measured in the one direction. The first contact electrode 261 and the second contact electrode 262 may be disposed to cover the side portions of the first electrode 210 and the second electrode 220 or the side portions of the first electrode branch 210B and the second electrode branch 220B. However, the disclosure is not limited thereto, and in some cases, the first contact electrode 261 and the second contact electrode 262 may be disposed to cover only one side portion of the first electrode branch 210B and the second electrode branch 220B.

Although it is illustrated in the drawing that two first contact electrodes 261 and one second contact electrode 262 are disposed in one sub-pixel PXn, the disclosure is not limited thereto. The number of the first contact electrode 261 and the second contact electrode 262 may vary depending on the number of the first electrode 210 and the second electrode 220 disposed in each sub-pixel PXn or the number of the first electrode branch 210B and the second electrode branch 220B.

Meanwhile, although not shown in FIGS. 2 and 3, the display device 10 may further include the circuit element layer PAL positioned under the electrodes 210 and 220 and a plurality of insulating layers disposed thereon. Hereinafter, the stacked structure of the display device 10 will be elaborated with reference to FIG. 4.

FIG. 4 is a cross-sectional view taken along lines Xa-Xa', Xb-Xb' and Xc-Xc' of FIG. 3.

FIG. 4 only shows a cross section of the first sub-pixel PX1, but the same may be applied to other pixels PX or sub-pixels PXn. FIG. 4 shows a cross section passing through one end and the other end of the light emitting element 300 disposed in the first sub-pixel PX1.

Referring to FIG. 4 in conjunction with FIGS. 2 and 3, the display device 10 may include the circuit element layer PAL and an emission layer EML. The circuit element layer PAL may include a substrate 110, a buffer layer 115, a light blocking layer BML, conductive wires 191 and 192, first and second transistors 120 and 140, and the like, and the emission layer EML may include the above-described plurality of electrodes 210 and 220, the light emitting element 300, the plurality of contact electrodes 261 and 262, the plurality of insulating layers 510, 520, 530, 550, and the like.

Specifically, the substrate 110 may be an insulating substrate. The substrate 110 may be made of an insulating material such as glass, quartz, or polymer resin. Further, the substrate 110 may be a rigid substrate, but may also be a flexible substrate which can be bent, folded or rolled.

The light blocking layer BML may be disposed on the substrate 110. The light blocking layer BML may include a first light blocking layer BML1 and a second light blocking layer BML2. The first light blocking layer BML1 may be electrically connected with a first source electrode 123 of the first transistor 120 to be described later. The second light blocking layer BML2 may be electrically connected with a second source electrode 143 of the second transistor 140.

The first light blocking layer BML1 and the second light blocking layer BML2 are arranged to overlap a first active material layer 126 of the first transistor 120 and a second active material layer 146 of the second transistor 140, respectively. The first and second light blocking layers BML1 and BML2 may include a material that blocks light, and thus can prevent light from reaching the first and second active material layers 126 and 146. For example, the first and second light blocking layers BML1 and BML2 may be formed of an opaque metal material that blocks light transmission. However, the disclosure is not limited thereto, and in some cases, the light blocking layer BML may be omitted.

The buffer layer 115 is disposed on the light blocking layer BML and the substrate 110. The buffer layer 115 may be disposed to cover the entire surface of the substrate 110, including the light blocking layer BML. The buffer layer 115 can prevent diffusion of impurity ions, prevent penetration of moisture or external air, and perform a surface planarization function. Furthermore, the buffer layer 115 may serve to insulate the light blocking layer BML and the first and second active material layers 126 and 146 from each other.

A semiconductor layer is disposed on the buffer layer 115. The semiconductor layer may include the first active material layer 126 of the first transistor 120, the second active material layer 146 of the second transistor 140, and an auxiliary layer 163. The semiconductor layer may include polycrystalline silicon, monocrystalline silicon, oxide semiconductor, and the like.

The first active material layer 126 may include a first doped region 126a, a second doped region 126b, and a first channel region 126c. The first channel region 126c may be disposed between the first doped region 126a and the second doped region 126b. The second active material layer 146 may include a third doped region 146a, a fourth doped region 146b, and a second channel region 146c. The second channel region 146c may be disposed between the third doped region 146a and the fourth doped region 146b. The first active material layer 126 and the second active material layer 146 may include polycrystalline silicon. The polycrystalline silicon may be formed by crystallizing amorphous silicon. Examples of the crystallizing method may include rapid thermal annealing (RTA), solid phase crystallization (SPC), excimer laser annealing (ELA), metal-induced lateral crystallization (MILC), and sequential lateral solidification (SLS), but are not limited thereto. As another example, the first active material layer 126 and the second active material layer 146 may include monocrystal silicon, low-temperature polycrystalline silicon, amorphous silicon, or the like. The first doped region 126a, the second doped region 126b, the third doped region 146a, and the fourth doped region 146b may be some areas of the first active material layer 126 and the second active material layer 146 doped with impurities. However, the disclosure is not limited thereto.

However, the first active material layer 126 and the second active material layer 146 are not necessarily limited to the above-described ones. In an embodiment, the first active material layer 126 and the second active material layer 146 may include an oxide semiconductor. In this case, the first doped region 126a and the third doped region 146a may be a first conductive region, and the second doped region 126b and the fourth doped region 146b may be a second conductive region. When the first active material layer 126 and the second active material layer 146 include an oxide semiconductor, the oxide semiconductor may be an oxide semiconductor containing indium (In). In some embodiments, the oxide semiconductor may be indium tin oxide (ITO), indium zinc oxide (IZO), indium gallium oxide (IGO), indium zinc tin oxide (IZTO), indium gallium tin oxide (IGTO), indium gallium zinc tin oxide (IGZTO) or the like. However, the disclosure is not limited thereto.

A first gate insulating film 150 is disposed on the semiconductor layer. The first gate insulating film 150 may be disposed to cover the entire surface of the buffer layer 115, including the semiconductor layer. The first gate insulating film 150 may function as a gate insulating film for the first and second transistors 120 and 140.

A first conductive layer is disposed on the first gate insulating film 150. The first conductive layer may include a first gate electrode 121 disposed on the first active material layer 126 of the first transistor 120, a second gate electrode 141 disposed on the second active material layer 146 of the second transistor 140, and a wiring pattern 161 disposed on the auxiliary layer 163 on the first gate insulating film 150. The first gate electrode 121 may overlap the first channel region 126c of the first active material layer 126, and the second gate electrode 141 may overlap the second channel region 146c of the second active material layer 146.

An interlayer insulating film 170 is disposed on the first conductive layer. The interlayer insulating film 170 may function as an insulating film between the first conductive layer and other layers disposed thereon. In addition, the interlayer insulating film 170 may contain an organic insulating material and may also perform a surface planarization function.

A second conductive layer is disposed on the interlayer insulating film 170. The second conductive layer includes the first source electrode 123 and the first drain electrode 124 of the first transistor 120, the second source electrode 143 and the second drain electrode 144 of the second transistor 140, and a power electrode 162 disposed on the wiring pattern 161.

The first source electrode 123 and the first drain electrode 124 may be in contact with the first doped region 126a and the second doped region 126b of the first active material layer 126, respectively, via contact holes formed through the interlayer insulation film 170 and the first gate insulating film 150. The second source electrode 143 and the second drain electrode 144 may be in contact with the third doped region 146a and the fourth doped region 146b of the second active material layer 146, respectively, via contact holes formed through the interlayer insulation film 170 and the first gate insulating film 150. Further, the first source electrode 123 and the second source electrode 143 may be electrically connected with the first light blocking layer BML1 and the second light blocking layer BML2, respectively, via other contact holes.

A passivation film 180 may be disposed on the second conductive layer. The passivation film 180 may be disposed to cover the second conductive layer and may be disposed on the entire interlayer insulating film 170. That is, the passivation film 180 may be disposed to cover the first source electrode 123, the first drain electrode 124, the second source electrode 143, and the second drain electrode 144.

A conductive wiring layer may be disposed on the passivation film 180. The conductive wiring layer may include a first conductive wire 191 and a second conductive wire 192, and they may be electrically connected to the first source electrode 123 of the first transistor 120 and the power electrode 162, respectively. The conductive wiring layer may also be electrically connected to the first electrode 210 and the second electrode 220 of the emission layer EML, and may transmit electrical signals applied from the first transistor 120 and the power electrode 162 to the electrodes 210 and 220.

A first insulating layer 510 is disposed on the conductive wiring layer. The first insulating layer 510 contains an organic insulating material, and may perform a surface planarization function.

The plurality of internal banks 410 and 420, the external bank 430 (see FIG. 4), the plurality of electrodes 210 and 220, and the light emitting element 300 may be disposed on the first insulating layer 510.

As described above, the external bank 430 may extend in the first direction DR1 or the second direction DR2 to be disposed at the boundary between the subpixels PXn. That is, the external bank 430 may delimit the boundary of each sub-pixel PXn.

Although not shown, the external banks 430 may function to prevent ink from going over the boundaries of the sub-pixels PXn when jetting the ink in which the light emitting elements 300 are dispersed using an inkjet printing device in the manufacture of the display device 10. The external bank 430 may separate inks in which different light emitting elements 300 are dispersed for different sub-pixels PXn so as not to be mixed with each other. However, the disclosure is not limited thereto.

The plurality of internal banks 410 and 420 may be disposed to be spaced apart from each other in each sub-pixel PXn. The multiple internal banks 410 and 420 may include the first internal bank 410 and the second internal bank 420 disposed adjacent to the center of each sub-pixel PXn.

The first internal bank 410 and the second internal bank 420 are disposed to face each other. The first electrode 210 may be disposed on the first internal bank 410, and the second electrode 220 may be disposed on the second internal bank 420. Referring to FIGS. 3 and 4, it can be understood that the first electrode branch 210B is disposed on the first internal bank 410, and the second electrode branch 220B is disposed on the second internal bank 420.

Similarly to the first electrode 210 and the second electrode 220, the first internal bank 410 and the second internal bank 420 may be disposed to extend in the second direction DR2 in each sub-pixel PXn. Though not illustrated in the drawing, the first internal bank 410 and the second internal bank 420 may extend in the second direction DR2 toward the sub-pixels PXn adjacent in the second direction DR2. However, the disclosure is not limited thereto, and the first internal bank 410 and the second internal bank 420 may be disposed in each of the sub-pixels PXn separately, forming a pattern on the entire surface of the display device 10.

Each of the first internal bank 410 and the second internal bank 420 may have a structure with at least a part thereof protruding above the first insulating layer 510. Each of the first internal bank 410 and the second internal bank 420 may protrude above the plane on which the light emitting element 300 is disposed, and at least a part of this protruding portion may have a slope. The shape of the protruding portions of the first and second internal banks 410 and 420 is not particularly limited. Since the internal banks 410 and 420 protrude with respect to the first insulating layer 510 and have inclined side surfaces, the light emitted from the light emitting element 300 may be reflected by the inclined side surfaces of the internal banks 410 and 420. As will be described later, when the electrodes 210 and 220 disposed on the internal banks 410 and 420 include a material having high reflectivity, the light emitted from the light emitting element 300 may be reflected by the electrodes 210 and 220 positioned on the inclined side surfaces of the internal banks 410 and 420 and travel in an upward direction of the first insulating layer 510.

In other words, the external bank 430 may delimit adjacent sub-pixels PXn and perform a function of preventing ink from overflowing to an adjacent sub-pixels PXn in an inkjet process, whereas the internal banks 410 and 420 may have a protruding structure in each sub-pixel PXn and perform a function of a reflective partition wall for reflecting the light emitted from the light emitting element 300 in the upward direction of the first insulating layer 510. However, the disclosure is not limited thereto. Meanwhile, the plurality of internal banks 410 and 420 and external banks 430 may include, but are not limited to, polyimide (PI).

The plurality of electrodes 210 and 220 may be disposed on the first insulating layer 510 and the internal banks 410 and 420, respectively. As stated above, the electrodes 210 and 220 include the electrode stems 210S and 220S and the electrode branches 210B and 220B, respectively. The line Xa-Xa' of FIG. 3 is a line that crosses the first electrode stem 210S, the line Xb-Xb' of FIG. 3 is a line that crosses the first and second electrode branches 210B and 220B, and the line Xc-Xc' of FIG. 3 is a line that crosses the second electrode stem 220S. That is, the first electrode 210 disposed in the area Xa-Xa' of FIG. 4 can be understood to be the first electrode stem 210S; the first electrode 210 and the second electrode 220 disposed in the area Xb-Xb' of FIG. 4 can be understood to be the first electrode branch 210B and the second electrode branch 220B, respectively; and the second electrode 220 disposed in the area Xc-Xc' of FIG. 4 can be understood to be the second electrode stem 220S. The electrode stems 210S and the electrode branch 210B may constitute the first electrode 210, and the electrode stem 220S and the electrode branch 220B may constitute the second electrode 220.

Some areas of the first and second electrodes 210 and 220 may be disposed on the first insulating layer 510, and some other areas thereof may be disposed on the first and second internal banks 410 and 420, respectively. That is, the widths of the first electrode 210 and the second electrode 220 may be greater than the widths of the internal banks 410 and 420. Parts of the bottom surfaces of the first electrode 210 and the second electrode 220 may be in contact with the first insulating layer 510, and other parts thereof may be in contact with the internal banks 410 and 420.

Although not illustrated in the drawings, the first electrode stem 210S of the first electrode 210 and the second electrode stem 220S of the second electrode 220 which extend in the first direction DR1 may partially overlap the first internal bank 410 and the second internal bank 420, respectively. However, the disclosure is not limited thereto, and the first electrode stem 210S and the second electrode stem 220S may not overlap the first internal bank 410 and the second internal bank 420, respectively.

The first electrode contact hole CNTD may be formed in the first electrode stem 210S of the first electrode 210 to penetrate the first insulating layer 510 and expose a part of the first conductive wire 191. The first electrode 210 may be in contact with the first conductive wire 191 through the first electrode contact hole CNTD, and the first electrode 210 may be electrically connected to the first source electrode 123 of the first transistor 120 to receive an electrical signal.

The second electrode contact hole CNTS may be formed in the second electrode stem 220S of the second electrode 220 to penetrate the first insulating layer 510 and expose a part of the second conductive wire 192. The second electrode 220 may be in contact with the second conductive wire 192 through the second electrode contact hole CNTS, and the second electrode 220 may be electrically connected to the power electrode 162 to receive an electrical signal.

Some areas of the first electrode 210 and the second electrode 220, for example, the first electrode branch 210B and the second electrode branch 220B may be disposed to cover the first internal bank 410 and the second internal bank 420, respectively. The first electrode 210 and the second electrode 220 may face each other with a gap therebetween, and the plurality of light emitting elements 300 may be disposed therebetween.

Each of the electrodes 210 and 220 may include a transparent conductive material. For example, each of the electrodes 210 and 220 may include a material such as indium tin oxide (ITO), indium zinc oxide (IZO), and indium tin zinc oxide (ITZO), but is not limited thereto. In some embodiments, each of the electrodes 210 and 220 may include a conductive material having high reflectivity. For example, each of the electrodes 210 and 220 may include, as a material having high reflectivity, metal such as silver (Ag), copper (Cu), or aluminium (Al). In this case, light incident to each of the electrodes 210 and 220 may be reflected to be radiated in an upward direction of each sub-pixel PXn.

Further, each of the electrodes 210 and 220 may have a structure in which at least one transparent conductive material and at least one metal layer having high reflectivity are stacked, or may be formed as one layer including them. In an embodiment, each of the electrodes 210 and 220 may have a stacked structure of ITO/silver(Ag)/ITO/IZO, or may be made of an alloy including aluminium (Al), nickel (Ni), and lanthanum (La). However, the disclosure is not limited thereto.

The second insulating layer 520 is disposed on the first insulating layer 510, the first electrode 210, and the second electrode 220. The second insulating layer 520 is disposed to partially cover the first electrode 210 and the second electrode 220. The second insulating layer 520 may be disposed to cover most of the top surfaces of the first electrode 210 and the second electrode 220, and the openings (not shown) exposing parts of the first electrode 210 and the second electrode 220 may be formed in the second insulating layer 520. The openings of the second insulating layer 520 may be positioned to expose the relatively flat top surfaces of the first electrode 210 and the second electrode 220.

In an embodiment, the second insulating layer 520 may be formed to have a step such that a portion of the top surface thereof is recessed between the first electrode 210 and the second electrode 220. In some embodiments, the second insulating layer 520 may contain an inorganic insulating material, and a part of the top surface of the second insulating layer 520 disposed to cover the first electrode 210 and the second electrode 220 may be recessed by the step formed by the electrodes 210 and 220. The light emitting element 300 disposed on the second insulating layer 520 between the first electrode 210 and the second electrode 220 may form an empty space with respect to the recessed top surface of the second insulating layer 520. The light emitting element 300 may be disposed partially spaced apart from the top surface of the second insulating layer 520 with a clearance therebetween, and this clearance may be filled with a material forming the third insulating layer 530 to be described later.

However, the disclosure is not limited thereto. The second insulating layer 520 may include a flat top surface so that the light emitting element 300 is disposed thereon. The top surface may extend in one direction toward the first electrode 210 and the second electrode 220, and may be terminated on inclined side surfaces of the first electrode 210 and the second electrode 220. That is, the second insulating layer 520 may be disposed in an area where the electrodes 210 and 220 overlap the inclined side surfaces of the first internal bank 410 and the second internal bank 420, respectively. The contact electrode 260 to be described later may be in contact with the exposed areas of the first and second electrodes 210 and 220, and may be smoothly in contact with an end of the light emitting element 300 on the flat top surface of the second insulating layer 520.

The second insulating layer 520 may protect the first electrode 210 and the second electrode 220 while insulating them from each other. Further, it is possible to prevent the light emitting element 300 disposed on the second insulating layer 520 from being damaged by direct contact with other members. However, the shape and structure of the second insulating layer 520 are not limited thereto.

The light emitting element 300 may be disposed on the second insulating layer 520 between the electrodes 210 and 220. For example, at least one light emitting element 300 may be disposed on the second insulating layer 520 disposed between the electrode branches 210B and 220B. However, the disclosure is not limited thereto, and although not illustrated in the drawings, at least some of the light emitting elements 300 disposed in each sub-pixel PXn may be placed in a region other than the region between the electrode branches 210B and 220B. Further, the light emitting element 300 may be disposed such that some areas thereof overlap the electrodes 210 and 220. The light emitting element 300 may be disposed on ends where the first electrode branch 210B and the second electrode branch 220B face each other.

In the light emitting element 300, a plurality of layers may be disposed in a direction parallel to the first insulating layer 510. The light emitting element 300 of the display device 10 according to one embodiment may have a shape extending in one direction and may have a structure in which a plurality of semiconductor layers are sequentially arranged in one direction. In the light emitting element 300, the first semiconductor layer 310, the active layer 330, the second semiconductor layer 320, and an electrode layer 370 may be sequentially disposed along one direction, and the outer surfaces thereof may be surrounded by the insulating film 380. The light emitting element 300 disposed in the display device 10 may be disposed such that one extension direction is parallel to the first insulating layer 510, and the plurality of semiconductor layers included in the light emitting element 300 may be sequentially disposed along the direction parallel to the top surface of the first insulating layer 510. However, the disclosure is not limited thereto. In some cases, when the light emitting element 300 has a different structure, a plurality of layers may be arranged in a direction perpendicular to the first insulating layer 510.

Further, one end of the light emitting element 300 may be in contact with the first contact electrode 261, and the other end thereof may be in contact with the second contact electrode 262. In accordance with one embodiment, since the end surfaces of the light emitting element 300 in one direction in which it extends are exposed without the insulating film 380 formed thereon, the light emitting element 300 may be in contact with the first contact electrode 261 and the second contact electrode 262 to be described later in the exposed regions. However, the disclosure is not limited thereto. In some cases, in the light emitting element 300, at least some regions of the insulating film 380 may be removed, and the insulating film 380 may be removed to partially expose both end side surfaces of the light emitting element 300. During the manufacturing process of the display device 10, in the step of forming the third insulating layer 530 covering the outer surface of the light emitting element 300, the insulating film 380 may be partially removed. The exposed side surfaces of the light emitting element 300 may be in contact with the first contact electrode 261 and the second contact electrode 262. However, the disclosure is not limited thereto.

The third insulating layer 530 may be partially disposed on the light emitting element 300 disposed between the first electrode 210 and the second electrode 220. The third insulating layer 530 may be disposed to partially surround the outer surface of the light emitting element 300 to protect the light emitting element 300 and may perform a function of fixing the light emitting element 300 during the manufacturing process of the display device 10. In accordance with one embodiment, the third insulating layer 530 may be disposed on the light emitting element 300, and may expose one end and the other end of the light emitting element 300. One end and the other end of the light emitting element 300 that are exposed may be in contact with the contact electrode 260, so that electrical signals may be received from the electrodes 210 and 220. The shape of the third insulating layer 530 may be formed by a patterning process using a material forming the third insulating layer 530 using a conventional mask process. The mask for forming the third insulating layer 530 may have a width smaller than the length of the light emitting element 300, and the material forming the third insulating layer 530 may be patterned such that both ends of the light emitting element 300 are exposed. However, the disclosure is not limited thereto.

Further, in an embodiment, a portion of the material of the third insulating layer 530 may be disposed between the bottom surface of the light emitting element 300 and the second insulating layer 520. The third insulating layer 530 may be formed to fill a space between the second insulating layer 520 and the light emitting element 300 formed during the manufacturing process of the display device 10. Accordingly, the third insulating layer 530 may be formed to surround the outer surface of the light emitting element 300. However, the disclosure is not limited thereto.

The third insulating layer 530 may extend in the second direction DR2 between the first electrode branch 210B and the second electrode branch 220B in plan view. For example, the third insulating layer 530 may have an island shape or a linear shape on the first insulating layer 510 in plan view.

The first contact electrode 261 is disposed on the electrode 210 and the third insulating layer 530, and the second contact electrode 262 is disposed on the electrode 220 and the third insulating layer 530. The third insulating layer 530 may be disposed between the first contact electrode 261 and the second contact electrode 262, and may insulate them from each other to prevent direct contact between the first contact electrode 261 and the second contact electrode 262.

As described above, the first contact electrode 261 and the second contact electrode 262 may be in contact with at least one end of the light emitting element 300, and the first contact electrode 261 and the second contact electrode 262 may be electrically connected to the first electrode 210 or the second electrode 220 to receive an electrical signal.

The first contact electrode 261 may be in contact with the exposed area of the first electrode 210 on the first internal bank 410, and the second contact electrode 262 may be in contact with the exposed area of the second electrode 220 on the second internal bank 420. The first contact electrode 261 and the second contact electrode 262 may respectively transmit electrical signals transmitted from the electrodes 210 and 220 to the light emitting element 300.

The contact electrode 260 may include a conductive material. For example, they may include ITO, IZO, ITZO, aluminium (Al), or the like. However, the disclosure is not limited thereto.

A passivation layer 550 may be disposed on the contact electrode 260 and the third insulating layer 530. The passivation layer 550 may function to protect the members disposed on the first insulating layer 510 from the external environment.

Each of the first insulating layer 510, the second insulating layer 520, the third insulating layer 530, and the passivation layer 550 described above may include an inorganic insulating material or an organic insulating material. In an embodiment, the first insulating layer 510, the second insulating layer 520, the third insulating layer 530, and the passivation layer 550 may include an inorganic insulating material such as silicon oxide ($SiO_x$), silicon nitride ($SiN_x$), silicon oxynitride ($SiO_xN_y$), aluminium oxide ($Al_2O_3$), aluminium nitride (AlN), and the like. The first insulating layer 510, the second insulating layer 520, the third insulating layer 530, and the passivation layer 550 may include an organic insulating material such as acrylic resin, epoxy resin, phenolic resin, polyamide resin, polyimide resin, unsaturated polyester resin, polyphenylene resin, polyphenylene sulfide resin, benzocyclobutene, cardo resin, siloxane resin, silsesquioxane resin, polymethylmethacrylate, polycarbonate, and polymethylmethacrylate-polycarbonate synthetic resin. However, the disclosure is not limited thereto.

Meanwhile, the display device 10 according to one embodiment may include the light emitting element 300 including the electrode layer 370 and the insulating film 380, each having a thickness of a certain level or more. The light emitting element 300 according to one embodiment may prevent the active layer 330 from being damaged or the electrode layer 370 from being removed during the manufacturing process of the light emitting element 300 and the manufacturing process of the display device 10, and may improve the luminous efficiency and the luminous reliability of the light emitting element 300. Hereinafter, the light emitting element 300 according to one embodiment will be described in detail with reference to other drawings.

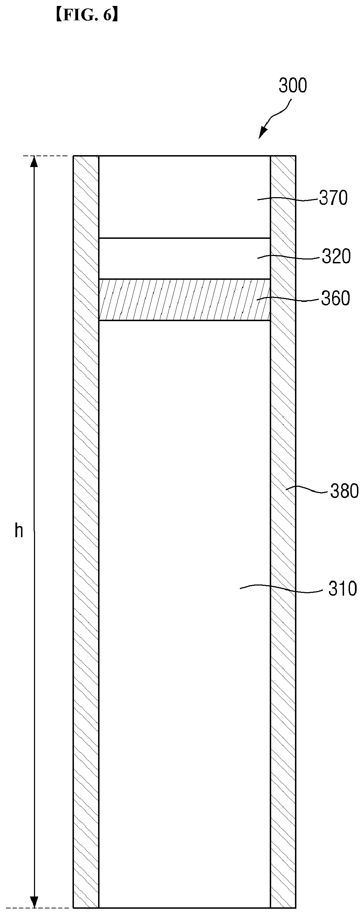

FIG. 5 is a schematic diagram of a light emitting element according to one embodiment. FIG. 6 is a schematic cross-sectional view of a light emitting element according to one embodiment.

A light emitting element 300 may be a light emitting diode. Specifically, the light emitting element 300 may be an inorganic light emitting diode that has a micrometer or nanometer size, and is made of an inorganic material. The inorganic light emitting diode may be aligned between two electrodes having polarity when an electric field is formed in a specific direction between two electrodes opposing each other. The light emitting element 300 may be aligned between two electrodes by the electric field generated between the electrodes.

The light emitting element 300 according to one embodiment may have a shape extending in one direction. The light emitting element 300 may have a shape of a rod, wire, tube, or the like. In an embodiment, the light emitting element 300 may have a cylindrical or rod shape. However, the shape of the light emitting element 300 is not limited thereto, and the light emitting element 300 may have a polygonal prism shape such as a regular cube, a rectangular parallelepiped and a hexagonal prism, or may have various shapes such as a shape extending in one direction and having an outer surface partially inclined. A plurality of semiconductors included in the light emitting element 300 to be described later may have a structure in which they are sequentially arranged or stacked along the one direction.

The light emitting element 300 may include a semiconductor layer doped with any conductivity type (e.g., p-type or n-type) impurities. The semiconductor layer may emit light of a specific wavelength band by receiving an electrical signal applied from an external power source.

The light emitting element 300 according to one embodiment may emit light of a specific wavelength band. In an embodiment, an active layer 330 may emit blue light having a central wavelength band ranging from 450 nm to 495 nm. However, it should be understood that the central wavelength band of blue light is not limited to the above-mentioned range but includes all wavelength ranges that can be recognized as blue in the pertinent art. Further, the light emitted from the active layer 330 of the light emitting element 300 may not be limited thereto, and may be green light having a central wavelength band ranging from 495 nm to 570 nm, or red light having a central wavelength band ranging from 620 nm to 750 nm. Hereinafter, the description will be provided on the assumption that the light emitting element 300 emits blue light, for example.

Referring to FIGS. 5 and 6, the light emitting element 300 may include the semiconductor core and the insulating film 380 surrounding the semiconductor core, and the semiconductor core of the light emitting element 300 may include the first semiconductor layer 310, the second semiconductor layer 320, and the active layer 330. Further, the light emitting element 300 according to one embodiment may further include the electrode layer 370 disposed on one surface of the first semiconductor layer 310 or the second semiconductor layer 320.

The first semiconductor layer 310 may be an n-type semiconductor. For example, when the light emitting element 300 emits light of a blue wavelength band, the first semiconductor layer 310 may include a semiconductor material having a chemical formula of $Al_xGa_yIn_{1-x-y}N$ ($0 \leq x \leq 1$, $0 \leq y \leq 1$, $0 \leq x+y \leq 1$). For example, it may be any one or more of n-type doped AlGaInN, GaN, AlGaN, InGaN, AlN and InN. The first semiconductor layer 310 may be doped with an n-type dopant. For example, the n-type dopant may be Si, Ge, Sn, or the like. In an embodiment, the first semiconductor layer 310 may be n-GaN doped with n-type Si. The length of the first semiconductor layer 310 may have a range of 1.5 $\mu$m to 5 $\mu$m, but is not limited thereto.

The second semiconductor layer 320 is disposed on the active layer 330 to be described later. The second semiconductor layer 320 may be a p-type semiconductor. For example, when the light emitting element 300 emits light of a blue or green wavelength band, the second semiconductor layer 320 may include a semiconductor material having a chemical formula of $Al_xGa_yIn_{1-x-y}N$ ($0 \leq x \leq 1$, $0 \leq y \leq 1$, $0 \leq x+y \leq 1$). For example, it may be any one or more of p-type doped AlGaInN, GaN, AlGaN, InGaN, AlN and InN. The second semiconductor layer 320 may be doped with a p-type dopant. For example, the p-type dopant may be Mg, Zn, Ca, Se, Ba, or the like. In an embodiment, the second semiconductor layer 320 may be p-GaN doped with p-type Mg. The length of the second semiconductor layer 320 may have a range of 0.05 $\mu$m to 0.10 $\mu$m, but is not limited thereto.

Meanwhile, although it is illustrated in the drawing that the first semiconductor layer 310 and the second semiconductor layer 320 are configured as a single layer, the disclosure is not limited thereto. According to some embodiments, depending on the material of the active layer 330, the first semiconductor layer 310 and the second semiconductor layer 320 may further include a larger number of layers, such as a cladding layer or a tensile strain barrier reducing (TSBR) layer. A description thereof will be given later with reference to other drawings.

The active layer 330 is disposed between the first semiconductor layer 310 and the second semiconductor layer 320. The active layer 330 may include a material having a single or multiple quantum well structure. When the active layer 330 includes a material having a multiple quantum well structure, a plurality of quantum layers and well layers may be stacked alternately. The active layer 330 may emit light by coupling of electron-hole pairs according to an electrical signal applied through the first semiconductor layer 310 and the second semiconductor layer 320. For example, when the active layer 330 emits light of a blue wavelength band, a material such as AlGaN or AlGaInN may be included. In particular, when the active layer 330 has a structure in which quantum layers and well layers are alternately stacked in a multiple quantum well structure, the quantum layer may include a material such as AlGaN or AlGaInN, and the well layer may include a material such as GaN or AlInN. In an embodiment, as described above, the active layer 330 includes AlGaInN as a quantum layer and AlInN as a well layer, and the active layer 330 may emit blue light having a central wavelength band of 450 nm to 495 nm.

However, the disclosure is not limited thereto, and the active layer 330 may have a structure in which semiconductor materials having large band gap energy and semiconductor materials having small band gap energy are alternately stacked, and may include other group III to V semiconductor materials according to the wavelength band of the emitted light. The light emitted by the active layer 330 is not limited to light of a blue wavelength band, but the active layer 330 may also emit light of a red or green wavelength band in some cases. The length of the active layer 330 may have a range of 0.05 $\mu$m to 0.10 $\mu$m, but is not limited thereto.

Meanwhile, light emitted from the active layer 330 may be emitted to both side surfaces as well as the outer surface of the light emitting element 300 in a longitudinal direction. The directionality of the light emitted from the active layer 330 is not limited to one direction.

The electrode layer 370 may be an ohmic contact electrode. However, the disclosure is not limited thereto, and it may be a Schottky contact electrode. The light emitting element 300 may include at least one electrode layer 370. Although FIG. 6 illustrates that the light emitting element 300 includes one electrode layer 370, the disclosure is not limited thereto. In some cases, the light emitting element 300 may include a larger number of electrode layers 370 or may be omitted. The following description of the light emitting element 300 may be equally applied even if the number of electrode layers 370 is different or further includes other structures.

In the display device 10 according to an embodiment, when the light emitting element 300 is electrically connected to an electrode or a contact electrode, the electrode layer 370 may reduce the resistance between the light emitting element 300 and the electrode or contact electrode. The electrode layer 370 may include a conductive metal. For example, the electrode layer 370 may include at least one of aluminium (Al), titanium (Ti), indium (In), gold (Au), silver (Ag), indium tin oxide (ITO), indium zinc oxide (IZO), or indium tin zinc oxide (ITZO). Further, the electrode layer 370 may include an n-type or p-type doped semiconductor material. The electrode layer 370 may include the same material or different materials, but is not limited thereto.

Meanwhile, in the light emitting element 300, the electrode layer 370 may be partially etched during the manufacturing process. As will be described later, in the process of forming the insulating film 380, the electrode layer 370 may be partially etched to have a thickness smaller than an initial thickness. In the light emitting element 300, the electrode layer 370 may have a thickness of a certain level or more in order to prevent the electrode layer 370 from being etched and removed during the above process. In the light emitting element 300 according to one embodiment, the thickness of the electrode layer 370 may be within a range of 20 nm to 200 nm, or within a range of 100 nm to 200 nm. When the electrode layer 370 has a thickness smaller than 20 nm, the electrode layer 370 may be etched and removed in the process of forming the insulating film 380, or contact failure with the second semiconductor layer 320 may occur. On the other hand, when the thickness of the electrode layer 370 is 200 nm or more, the light generated in the active layer 330 may be absorbed by the electrode layer 370, so that the optical characteristics of the light emitting element 300 may deteriorate. In order to prevent this, the electrode layer 370 of the light emitting element 300 may have a thickness of 20 nm or more, preferably within the range of 100 nm to 200 nm.

Meanwhile, in the light emitting element 300, the light generated in the active layer 330 may be emitted through both end surfaces, e.g., the top surface of the electrode layer 370 or the bottom surface of the first semiconductor layer 310. Here, the transmittance of the light generated in the active layer 330 may vary depending on the thickness of the electrode layer 370. However, the light emitting element 300 according to one embodiment may include the electrode layer 370 having a thickness within the above-described range and have the transmittance of a certain level or more. For example, when the active layer 330 generates blue light having a central wavelength band of about 450 nm, the electrode layer 370 may have the transmittance of 65% or more, or 70% or more with respect to the light having the central wavelength band of about 450 nm. However, the disclosure is not limited thereto.

Furthermore, in the light emitting element 300, since the electrode layer 370 has the thickness within the above-described range, the change in the transmittance with respect to the thickness may be minimized. That is, when the electrode layer 370 has a thickness of 20 nm to 200 nm, or 100 nm to 200 nm, the change in the transmittance with respect to the light having the central wavelength band of about 450 nm may be about 3% or about 1%. Accordingly, in the light emitting element 300, the thickness of the electrode layer 370 may be controlled to prevent the electrode layer 370 from being removed during the manufacturing process of the display device 10, and the emission characteristics and the element efficiency may be improved due to the transmittance of a certain level or more.

Further, in some embodiments, the electrode layer 370 of the light emitting element 300 may have a thickness greater than that of the second semiconductor layer 320. Due to the larger thickness of the electrode layer 370, the electrode layer 370 may be smoothly in contact with the second semiconductor layer 320 or the first contact electrode 261. To this end, in some cases, the electrode layer 370 of the light emitting element 300 may be formed to be thicker than the second semiconductor layer 320. However, the disclosure is not limited thereto.

The insulating film 380 is disposed to surround the outer surfaces of the above-described semiconductor core and electrode layer. In an embodiment, the insulating film 380 may be arranged to surround at least the outer surface of the active layer 330 and extend along the extension direction of the light emitting element 300. The insulating film 380 may function to protect the members. For example, the insulating film 380 may be formed to surround side surfaces of the members to expose both ends of the light emitting element 300 in the longitudinal direction.

Although it is illustrated in the drawing that the insulating film 380 extends in the longitudinal direction of the light emitting element 300 to cover a region from the first semiconductor layer 310 to the side surface of the electrode layer 370, the disclosure is not limited thereto. The insulating film 380 may cover only the outer surfaces of some semiconductor layers, including the active layer 330, or may cover only a part of the outer surface of the electrode layer 370 to partially expose the outer surface of each electrode layer 370. Further, in cross-sectional view, the insulating film 380 may have a top surface, which is rounded in a region adjacent to at least one end of the light emitting element 300.

The insulating film 380 may include materials having insulating properties, for example, silicon oxide (SiOx), silicon nitride (SiNx), silicon oxynitride (SiOxNy), aluminium nitride (AlN), aluminium oxide ($A_2O_3$), and the like. Accordingly, it is possible to prevent an electrical short circuit that may occur when the active layer 330 is in direct contact with the electrode through which the electrical signal is transmitted to the light emitting element 300. In addition, since the insulating film 380 protects the outer surface of the light emitting element 300 including the active layer 330, it is possible to prevent degradation in luminous efficiency.

Further, in some embodiments, the insulating film 380 may have an outer surface which is surface-treated. When the display device 10 is manufactured, the light emitting elements 300 may be aligned by being sprayed on the electrodes in a state of being dispersed in predetermined ink. Here, the surface of the insulating film 380 may be treated to have a hydrophobic property or hydrophilic property in order to keep the light emitting element 300 in the dispersed state without being aggregated with other neighboring light emitting elements 300 in the ink.

The light emitting element 300 may have a length of 1 μm to 10 μm or 2 μm to 6 μm, and preferably 3 μm to 5 μm. Further, a diameter of the light emitting element 300 may have a range of 300 nm to 700 nm, and an aspect ratio of the light emitting element 300 may be 1.2 to 100. However, the disclosure is not limited thereto, and the plurality of light emitting elements 300 included in the display device 10 may have different diameters according to a difference in composition of the active layer 330. Preferably, the diameter of the light emitting element 300 may have a range of about 500 nm.

Meanwhile, the insulating film 380 may include at least the active layer 330 to protect the semiconductor core of the light emitting element 300. As described above, during the manufacturing process of the light emitting element 300 and the manufacturing process of the display device 10, the insulating film 380 may be partially etched and have a reduced thickness. When the insulating film 380 has the reduced thickness, the insulating film 380 may be etched and removed during the manufacturing process, or the semiconductor core, particularly, the active layer 330 may be damaged. In order to prevent this, the insulating film 380 of the light emitting element 300 according to one embodiment may have a thickness of a certain level or more.

In the light emitting element 300 according to one embodiment, the insulating film 380 may have a thickness within a range of 10 nm to 1.0 μm, or within a range of 20 nm to 80 nm, preferably within a range of 60 nm to 80 nm. The insulating film 380 may have the thickness within the above-described range and may be disposed to surround at least the outer surface of the active layer 330. Accordingly, even if the insulating film 380 is partially etched during the manufacturing process of the light emitting element 300 and the manufacturing process of the display device 10, the insulating film 380 may remain on the outer surface of the active layer 330 and protect it. Meanwhile, it is illustrated in the drawing that the insulating film 380 is disposed to surround the entire outer surface of the semiconductor core including the active layer 330, and is disposed to surround the side surfaces of the first semiconductor layer 310 and the electrode layer 370. However, the disclosure is not limited thereto, and in the light emitting element 300, the insulating film 380 may not be disposed and the outer surface of the semiconductor core may be partially exposed.

Since the insulating film 380 has the thickness within the above-described range, the diameter of the semiconductor core and the thickness of the insulating film 380 may have a specific relationship in the light emitting element 300. For example, in the light emitting element 300, the thickness of the insulating film 380 may be within the range of 10% to 16% of the diameter of the semiconductor core. Since the insulating film 380 has the thickness within the above-described range, the semiconductor core, particularly, the active layer 330 may be protected.

Further, in some embodiments, the insulating film 380 may be disposed along the outer surface of the semiconductor core, but may not have a uniform thickness. The insulating film 380 may have different thicknesses on the outer surfaces of the first semiconductor layer 310, the active layer 330, the second semiconductor layer 320, and the electrode layer 370. This may be because the insulating film 380 is etched during the manufacturing process of the light emitting element 300 or is partially etched after the light emitting element 300 is disposed on the display device 10 to have different thicknesses depending on positions.

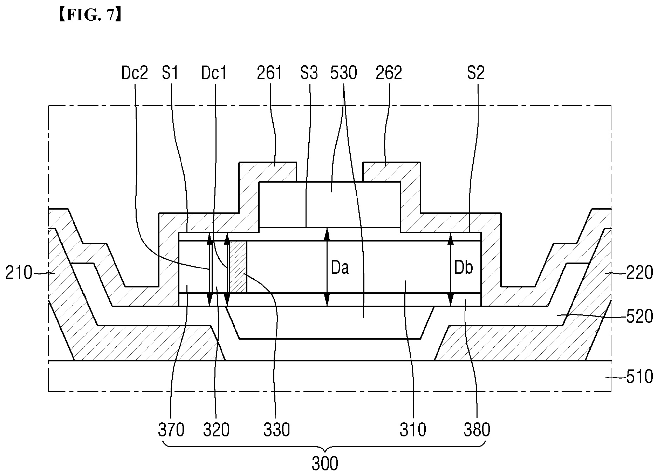

FIG. 7 is an enlarged view of part QA of FIG. 4.

FIG. 7 is an enlarged cross-sectional view illustrating the light emitting element 300 disposed between the first electrode 210 and the second electrode 220 in the display device 10. Referring to FIG. 7, the light emitting element 300 may be disposed on the second insulating layer 520 between the first electrode 210 and the second electrode 220. The light emitting element 300 may include, on the outer surface of the insulating film 380, one side surface that is a lower surface and the other side surface that is an upper surface in cross-sectional view. The one side surface may be in contact with the second insulating layer 520 and the third insulating layer 530 disposed on the lower side of the light emitting element 300, and the other side surface may be in contact with the insulating layer 530 and the contact electrode 260 disposed on the upper side of the light emitting element 300.

The one side surface that is the lower surface of the light emitting element 300 may be in contact with the second insulating layer 520, and may be in contact with the third insulating layer 530 in the space formed by partially recessing the second insulating layer 520 and filled with the third insulating layer 530. The one side surface that is the lower surface of the light emitting element 300 in cross-sectional view may not be etched during the manufacturing process of the display device 10. Accordingly, the contact surface between the second insulating layer 520 and the third insulating layer 530 may form a flat surface.

On the other hand, in the light emitting element 300, the other side surface that is the upper surface in cross-sectional view may be partially etched in the etching process performed before the process of forming the contact electrode 260. On the other side surface, the insulating film 380 may be etched in the region in contact with the contact electrode 260 except the portion in contact with the third insulating layer 530. The display device 10 according to one embodiment may include the region in which the thickness of the insulating film 380 of the light emitting element 300 is partially different. The other side surface may include a first surface S1 in contact with the first contact electrode 261, a second surface S2 in contact with the second contact electrode 262, and a third surface S3 in contact with the third insulating layer 530. On the other side surface, the first surface S1 and the second surface S2 may be partially etched before the process of forming the contact electrode 260, so that the insulating film 380 may have a relatively small thickness, and the third surface S3 may be in contact with the third insulating layer 530, so that the insulating film 380 may not be etched. Accordingly, the insulating film 380 may have a smaller thickness in the regions where the first surface S1 and the second surface S2 are positioned than in the region where the third surface S3 is positioned.

The thickness of the insulating film 380 of the light emitting element 300 may be the thickness of the region where the third surface S3 is positioned. That is, the light emitting element 300 of the display device 10 may have a thickness within the range of 60 nm to 80 nm in the region of the insulating film 380 where the third surface S3 is positioned or in the region in contact with the third insulating layer 530. On the other hand, the thickness may be within the range of 40 nm to 60 nm in the regions where the first surface S1 and the second surface S2 are positioned, or in the regions in contact with the first contact electrode 261 and the second contact electrode 262.

Accordingly, the light emitting element 300 disposed between the first electrode 210 and the second electrode 220 may have different diameters depending on positions. That is, the light emitting element 300 may have different diameters measured in the other direction perpendicular to the one extension direction. For example, a first diameter Da of the light emitting element 300 measured in the other direction in the region where the third surface S3 is positioned may be greater than a second diameter Db measured in the region where the second surface S2 is positioned and a third diameter Dc measured in the region where the first surface S1 is positioned. The first diameter Da, the second diameter Db, and the third diameter Dc may have different values because the insulating film 380 is partially etched during the manufacturing process of the display device 10 or the manufacturing process of the light emitting element 300.

Further, in the light emitting element 300, in the region where the first surface S1 is positioned, a third-first diameter Dc1 measured at the interface between the active layer 330 and the second semiconductor layer 320 and a third-second diameter Dc2 measured at the interface between the second semiconductor layer 320 and the electrode layer 370 may be further defined. Although it is illustrated in the drawing that the third-first diameter Dc1 and the third-second diameter Dc2 are equal, the disclosure is not limited thereto. In some embodiments, the third-first diameter Dc1 and the third-second diameter Dc2 may have different values, and the insulating film 380 may be formed to have an inclined outer surface in cross-sectional view. A description thereof may refer to other embodiments.

The region of the insulating film 380 where the first surface S1 is positioned or the region in contact with the first contact electrode 261 may be the region surrounding the active layer 330 and have a thickness of a certain level or more. The insulating film 380 of the light emitting element 300 according to one embodiment may have a thickness within a range of 60 nm to 80 nm, and at least some regions may have a thickness of 40 nm or more and 60 nm or less. In the region of the insulating film 380 where the first surface S1 is positioned, particularly in the region surrounding the active layer 330, the insulating film 380 may have the thickness of 40 nm or more even if it is partially etched during the manufacturing process, so that it is possible to prevent the exposure of the active layer 330 of the light emitting element 300. Since the insulating film 380 is formed to have a thickness of a certain level or more during the manufacturing process of the light emitting element 300, the light emitting element 300 disposed in the display device 10 may protect the active layer 330 even if the insulating film 380 is partially etched. Accordingly, the luminous efficiency and the luminous reliability of the light emitting element 300 may be improved.

Meanwhile, the display device 10 may further include a larger number of insulating layers. According to one embodiment, the display device 10 may further include a fourth insulating layer 540 disposed to protect the first contact electrode 261.

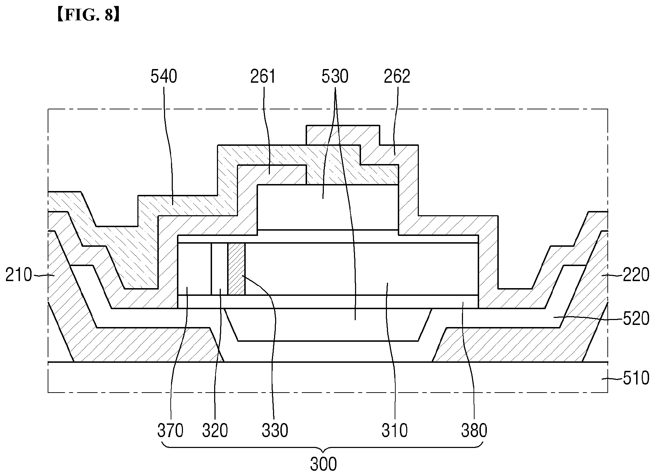

FIG. 8 is a cross-sectional view illustrating a part of a display device according to one embodiment.

Referring to FIG. 8, the display device 10 according to one embodiment may further include a fourth insulating layer 540 disposed on the first contact electrode 261. The display device 10 according to the embodiment is different from the display device 10 of FIG. 4 in that it further includes the fourth insulating layer 540 and at least a part of the second contact electrode 262 is disposed on the fourth insulating layer 540. In the following description, redundant description will be omitted while focusing on differences.

The display device 10 of FIG. 8 may include the fourth insulating layer 540 that is disposed on the first contact electrode 261 and electrically insulates the first contact electrode 261 and the second contact electrode 262 from each other. The fourth insulating layer 540 may be arranged to cover the first contact electrode 261 and not to overlap a partial region of the light emitting element 300 such that the light emitting element 300 is connected to the second contact electrode 262. The fourth insulating layer 540 may be partially in contact with the first contact electrode 261 and the third insulating layer 530 on the top surface of the third insulating layer 530. The fourth insulating layer 540 may be disposed on the third insulating layer 530 to cover one end of the first contact electrode 261. Accordingly, the fourth insulating layer 540 may protect the first contact electrode 261 and electrically insulate it from the second contact electrode 262.

A side surface of the fourth insulating layer 540 in a direction in which the second contact electrode 262 is disposed may be aligned with one side surface of the third insulating layer 530. However, the disclosure is not limited thereto. In some embodiments, the fourth insulating layer 540 may contain an inorganic insulating material, similar to the second insulating layer 520.

The first contact electrode 261 may be disposed between the first electrode 210 and the fourth insulating layer 540, and the second contact electrode 262 may be disposed on the fourth insulating layer 540. The second contact electrode 262 may be partially in contact with the second insulating layer 520, the third insulating layer 530, the fourth insulating layer 540, the second electrode 220, and the light emitting element 300. One end of the second contact electrode 262 in a direction in which the first electrode 210 is disposed may be disposed on the fourth insulating layer 540.

The passivation layer 550 may be disposed on the fourth insulating layer 540 and the second contact electrode 262 to protect them. Hereinafter, redundant description will be omitted.

Hereinafter, a manufacturing process of the light emitting element 300 according to one embodiment will be described.

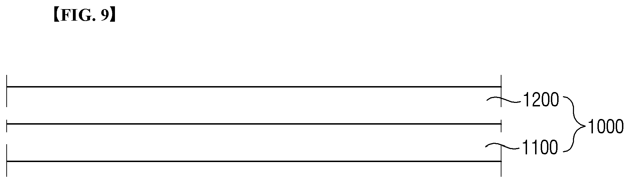

FIGS. 9 to 14 are cross-sectional views showing a manufacturing process of a light emitting element according to one embodiment.

First, referring to FIG. 9, a lower substrate 1000 including a base substrate 1100 and a buffer material layer 1200 formed on the base substrate 1100 is prepared. The base substrate 1100 may include a transparent substrate such as a sapphire ($Al_2O_3$) substrate and a glass substrate. However, the disclosure is not limited thereto, and it may be formed of a conductive substrate such as GaN, SiC, ZnO, Si, GaP and GaAs. The following description is directed to a case where the base substrate 1100 is a sapphire ($Al_2O_3$) substrate. Although not limited, the base substrate 1100 may have, for example, a thickness in the range of 400 $\mu$m to 1500 $\mu$m.

A plurality of semiconductor layers are formed on the base substrate 1100. The plurality of semiconductor layers grown by an epitaxial method may be formed by growing seed crystals. Here, the semiconductor layer may be formed using one of electron beam deposition, physical vapor deposition (PVD), chemical vapor deposition (CVD), plasma laser deposition (PLD), dualtype thermal evaporation, sputtering, and metal organic chemical vapor deposition (MOCVD), preferably, using the metal organic chemical vapor deposition (MOCVD). However, the disclosure is not limited thereto.

Typically, a precursor material for forming the plurality of semiconductor layers may be selected to form a target material in a typically selectable range without any limitation. For example, the precursor material may be a metal precursor including an alkyl group such as a methyl group or an ethyl group. Examples of the precursor material may include, but are not limited to, trimethylgallium $Ga(CH_3)_3$, trimethylaluminium $Al(CH_3)_3$, and triethyl phosphate $(C_2H_5)_3PO_4$. Hereinafter, with the omission of the description of the method and processing conditions for forming the plurality of semiconductor layers, a description is made of the processing order of the method for manufacturing the light emitting element 300 and the layered structure of the light emitting element 300 in detail.

A buffer material layer 1200 is formed on the base substrate 1100. Although it is shown in the drawing that one buffer material layer 1200 is deposited, the disclosure is not limited thereto, and a plurality of layers may be formed. The buffer material layer 1200 may be disposed to reduce a difference in lattice constant between a first semiconductor 3100 and the base substrate 1100.

For example, the buffer material layer 1200 may include an undoped semiconductor, and may be a material including substantially the same material as the first semiconductor 3100 and neither n-type doped nor p-type doped. In an embodiment, the buffer material layer 1200 may be, but is not limited to, at least one of undoped InAlGaN, GaN, AlGaN, InGaN, AlN, or InN. The buffer material layer 1200 may also be omitted depending on the base substrate 1100. The following description will be given for an example where the buffer material layer 1200 including an undoped semiconductor is formed on the base substrate 1100.

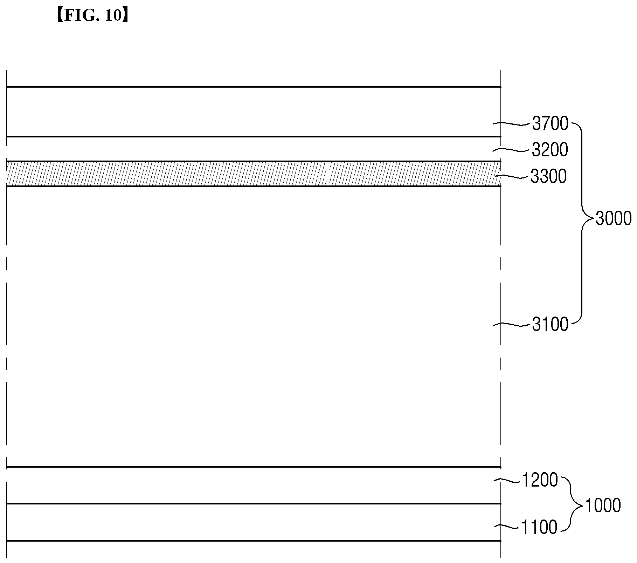

Next, as shown in FIG. 10, the semiconductor structure 3000 is formed on the underlying substrate 1000. The semiconductor structure 3000 may include a first semiconductor 3100, an active layer 3300, a second semiconductor 3200, and an electrode material layer 3700. The plurality of material layers included in the semiconductor structure 3000 may be formed by performing the typical processes as stated above, and the plurality of layers included in the semiconductor structure 3000 may correspond to the respective layers included in the light emitting element 300 according to one embodiment. That is, the plurality of material layers may include the same materials as the first semiconductor layer 310, the active layer 330, the second semiconductor layer 320, and the electrode layer 370 of the light emitting element 300.

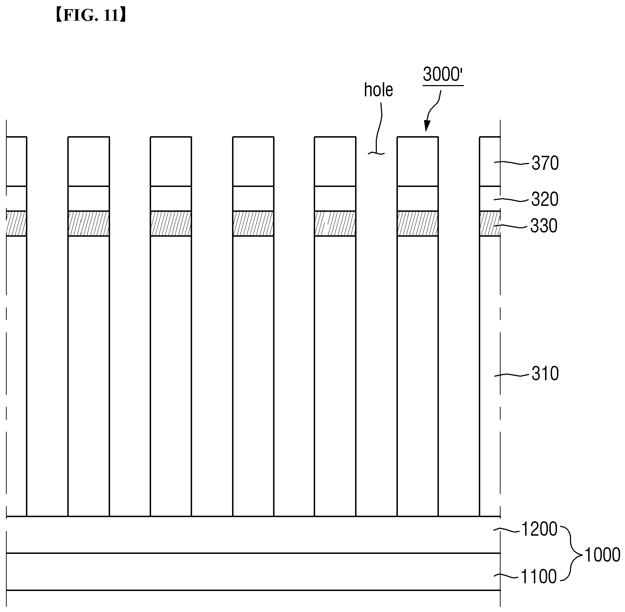

Next, referring to FIG. 11, the semiconductor structure 3000 is etched to form semiconductor cores 3000' spaced apart from each other. The semiconductor structure 3000 may be etched by a conventional method. For example, the semiconductor structure 3000 may be etched by a method of forming an etch mask layer thereon and etching the semiconductor structure 3000 along the etch mask layer in a direction perpendicular to the lower substrate 1000.

For example, the process of etching the semiconductor structure 3000 may be dry etching, wet etching, reactive ion etching (RIE), inductively coupled plasma reactive ion etching (ICP-RIE), or the like. The dry etching method may be suitable for vertical etching because anisotropic etching can be performed. In the case of using the aforementioned etching technique, it may be possible to use $Cl_2$ or $O_2$ as an etchant. However, the disclosure is not limited thereto.

In some embodiments, etching the semiconductor structure 3000 may be carried out with a combination of the dry etching and the wet etching. For example, it may be possible to perform etching in a depth direction with the dry etching and then anisotropic etching with the wet etching such that the etched sidewalls are placed on the plane perpendicular to the surface.

Next, an element rod ROD including the insulating film 380 partially surrounding the outer surface of the semiconductor core 3000' is formed.

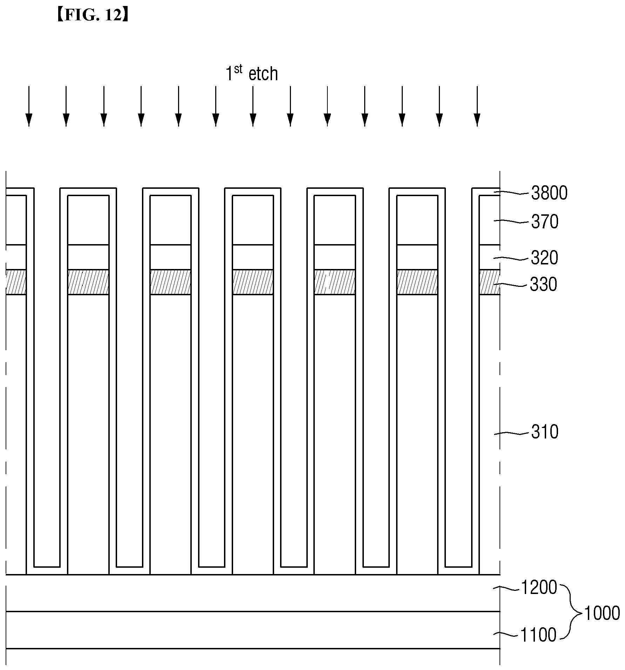

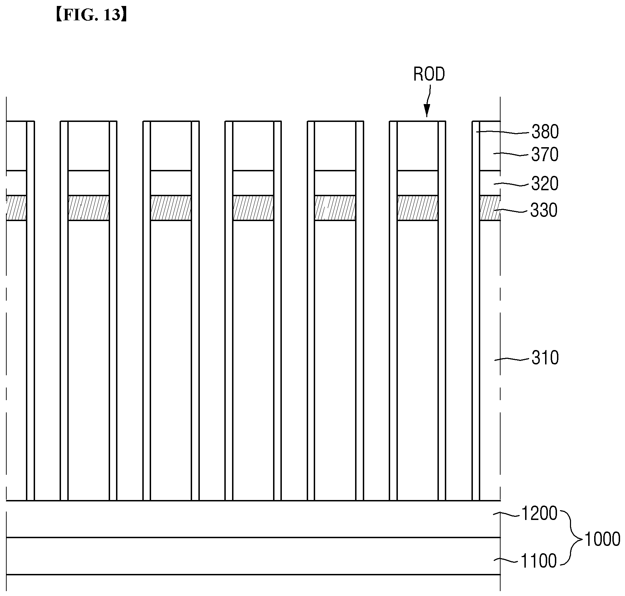

Referring to FIGS. 12 and 13, the insulating film 380 may be formed by forming an insulating coating film 3800 surrounding the outer surface of the semiconductor core 3000', and then partially removing the insulating coating film 3800 to expose one end of the semiconductor core 3000', e.g., the top surface of the electrode layer 370 (1st etch in FIG. 12).

The insulating coating film 3800 that is an insulating material formed on the outer surface of the semiconductor core 3000' may be formed using a method of coating or immersing an insulating material on the outer surface of the vertically etched semiconductor core 3000'. However, the disclosure is not limited thereto. For example, the insulating coating film 3800 may be formed using atomic layer deposition (ALD).

The insulating coating film 3800 may also be formed on the side surfaces and the top surfaces of the semiconductor cores 3000' and on the lower substrate 1000 exposed in the region where the semiconductor cores 3000' are spaced apart from each other. The partial removal of the insulating coating film 3800 may be carried out by etch-back or dry etching as anisotropic etching. In the drawing, the upper surface of the insulating coating film 3800 is removed to expose the electrode layer 370, and in this process, the electrode layer 370 may also be partially removed. That is, in the light emitting element 300, the thickness of the electrode layer 370 of the light emitting element 300 that is finally manufactured may be smaller than the thickness of the electrode material layer 3700 formed during the manufacturing process. As described above, since the thickness of the electrode layer 370 of the light emitting element 300 according to one embodiment may be 20 nm to 200 nm, or 100 nm to 200 nm, the thickness of the electrode material layer 3700 may be 200 nm or more. However, the disclosure is not limited thereto.

Although it is illustrated in the drawing that the top surface of the electrode layer 370 is exposed and the upper surface of the insulating film 380 is flat, the disclosure is not limited thereto. In some embodiments, the insulating film 380 may be formed to have a partially curved outer surface in an area where it surrounds the electrode layer 370. In the process of partially removing the insulating coating film 3800, a side surface of the insulating coating film 3800 as well as the top surface thereof may be partially removed, so that the insulating film 380 surrounding the multiple layers may be formed with a partially etched end surface. Particularly, as the top surface of the insulating coating film 3800 is removed, an outer surface of the insulating film 380 adjacent to the electrode layer 370 may be partially removed in the light emitting element 300.

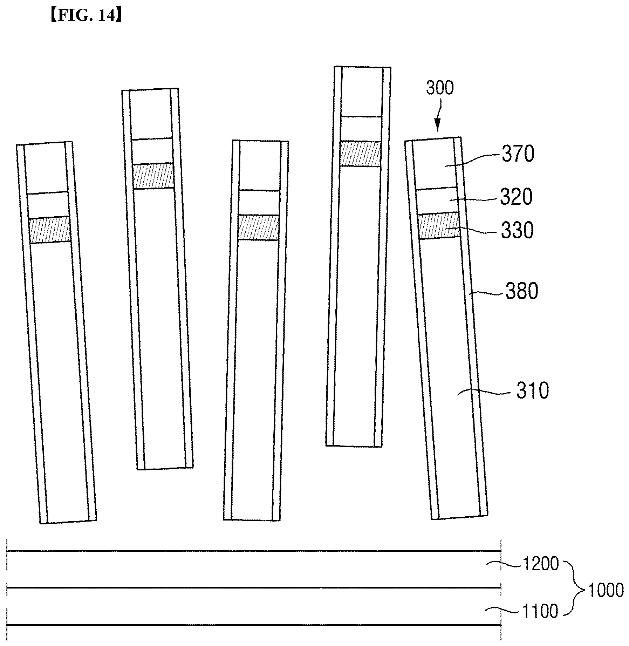

Finally, as shown in FIG. 14, the light emitting element 300 is manufactured by separating the element rod ROD on which the insulating film 380 is formed from the lower substrate 1000.

Through the above-described processes, the light emitting element 300 according to one embodiment may be manufactured. The light emitting element 300 manufactured as described above may be disposed between the first electrode 210 and the second electrode 220, and the display device 10 may be manufactured by arranging the third insulating layer 530, the contact electrode 260, and the like thereon. Next, the manufacturing process of the display device 10 will be described with further reference to other drawings.

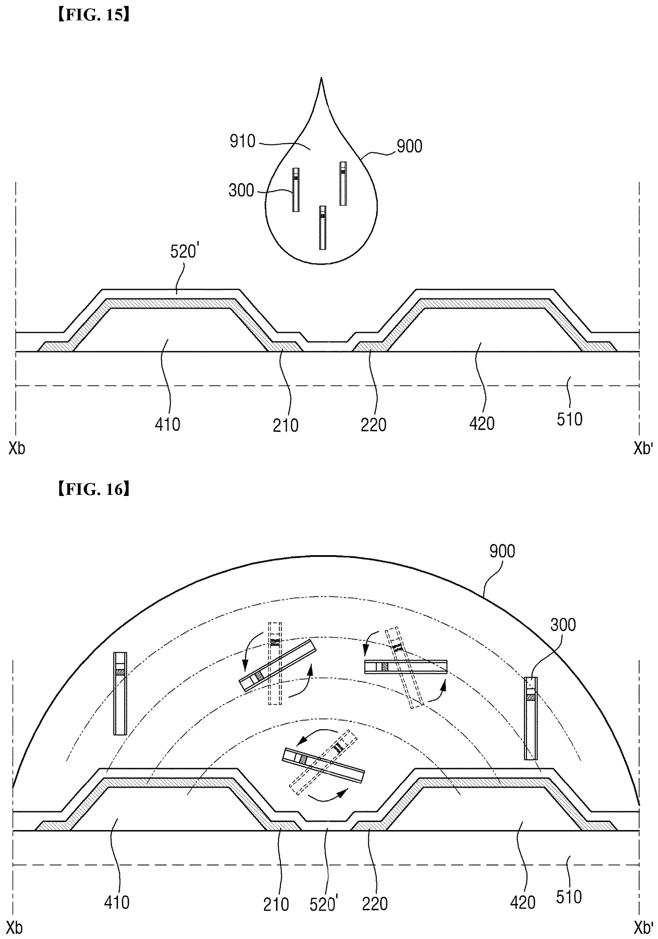

FIGS. 15 to 19 are cross-sectional views illustrating a part of a manufacturing process of a display device according to one embodiment.

First, referring to FIG. 15, the first insulating layer 510, the first internal bank 410 and the second internal bank 420 spaced apart from each other on the first insulating layer 510, the first electrode 210 and the second electrode 220 respectively disposed on the first internal bank 410 and the second internal bank 420, and a second insulating layer 520' covering the first electrode 210 and the second electrode 220 are prepared. The second insulating material layer 520' may be partially patterned in a subsequent process to form the second insulating layer 520 of the display device 10. The above members may be formed by patterning a metal, an inorganic material, or an organic material by performing a conventional mask process.

Next, an ink 900 including the light emitting elements 300 is sprayed on the first electrode 210 and the second electrode 220. The ink 900 may include a solvent 910 and the light emitting elements 300 dispersed in the solvent 910. The light emitting elements 300 may be sprayed on the electrodes 210 and 220 while being dispersed in the solvent 910, and may be aligned between the first electrode 210 and the second electrode 220 by an electrical signal applied in a subsequent process.

Next, referring to FIG. 16, the electrical signals may be applied to the first electrode 210 and the second electrode 220 to generate an electric field on the ink 900 including the light emitting elements 300. The light emitting elements 300 may receive a dielectrophoretic force induced by the electric field and may be mounted between the first electrode 210 and the second electrode 220 while the orientations and positions thereof are being changed.

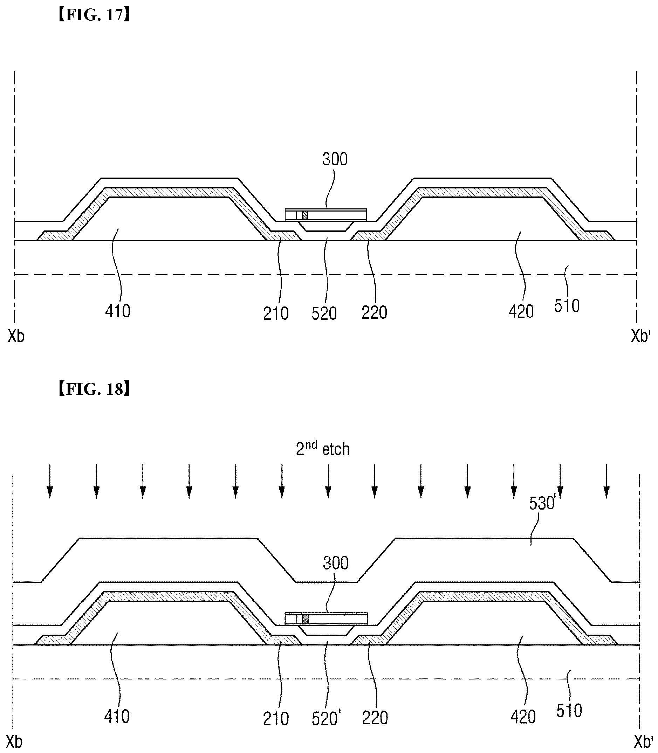

Next, referring to FIG. 17, the solvent 910 of the ink 900 is removed. Accordingly, the light emitting element 300 is disposed between the first electrode 210 and the second electrode 220, and the plurality of light emitting elements 300 mounted between the first electrode 210 and the second electrode 220 may be aligned with a specific orientation.

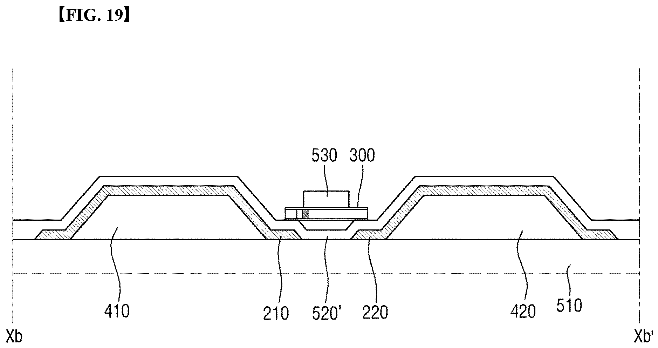

Next, referring to FIGS. 18 and 19, a third insulating material layer 530' is formed to cover the second insulating material layer 520' and the light emitting element 300, and then patterned to form the third insulating layer 530 (2nd etch in FIG. 18). The third insulating material layer 530' may be partially patterned by the

etching process (2nd etch) to form the third insulating layer 530. In the etching process (2nd etch) of the third insulating material layer 530', the outer surface of the light emitting element 300 may be partially exposed, and the insulating film 380 may be partially etched at this time. Accordingly, the exposed portion of the insulating film 380 where the third insulating layer 530 is not disposed, e.g., the region where the first surface S1 and the second surface S2 of FIG. 7 are positioned, may have a thickness smaller than that of the third surface S3 that is the portion in contact with the third insulating layer 530.

Thereafter, although not illustrated in the drawings, the second insulating material layer 520' may be patterned to form the second insulating layer 520, and the first contact electrode 261 and the second contact electrode 262, and the passivation layer 550 may be formed to manufacture the display device 10.

As described above, the light emitting element 300 and the display device 10 according to one embodiment may be manufactured. The electrode layer 370 of the light emitting element 300 may be partially etched and have a reduced thickness during the manufacturing process of the light emitting element 300, and the insulating film 380 of the light emitting element 300 may be partially etched and have a reduced thickness during the manufacturing process of the light emitting element 300 and the manufacturing process of the display device 10. The light emitting element 300 according to one embodiment may include the electrode layer 370 and the insulating film 380, each having a thickness of a certain level or more, to protect the active layer 330 and allow smooth contact between the electrode layer 370 and the second semiconductor layer 320. Accordingly, the light emitting element 300 included in the display device 10 may secure excellent luminous efficiency and luminous reliability.

Hereinafter, the light emitting element 300 and the display device 10 according to various embodiments will be described.

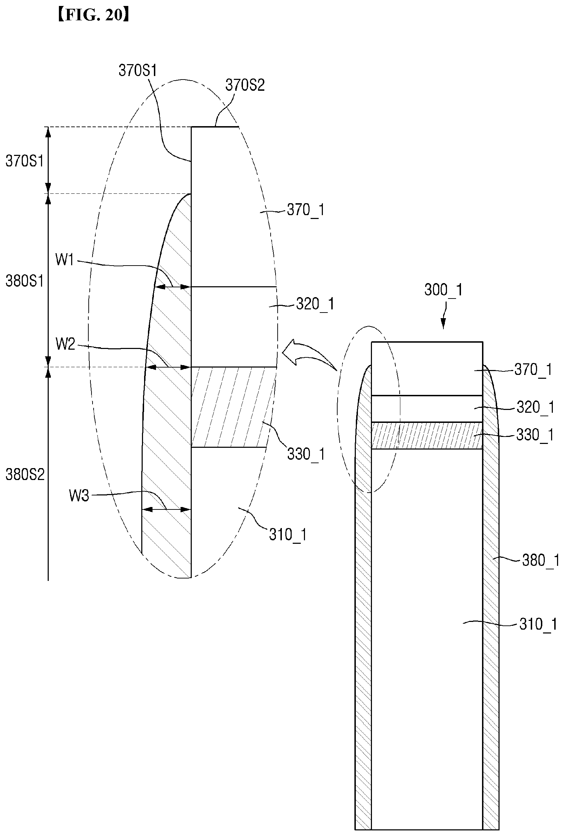

FIG. 20 is a schematic cross-sectional view of a light emitting element according to one embodiment.

Referring to FIG. 20, in a light emitting element 300_1 according to one embodiment, an insulating film 380_1 may have a partially inclined top surface or end surface and may include regions having different thicknesses. The light emitting element 300_1 of FIG. 20 is different from the light emitting element 300 of FIG. 6 in that the end surface of the insulating film 380_1 has the inclined shape. In addition, the arrangement and structures of the electrode layer 370, the first semiconductor layer 310, the active layer 330, and the like are the same as those of FIG. 6, and differences will be mainly described.

In accordance with one embodiment, the insulating film 380_1 may be disposed to expose a part of the semiconductor core, e.g., the side surface of an electrode layer 370_1, and the end surface of the portion of the insulating film 380_1 where the electrode layer 370_1 is exposed may have a partially inclined shape. The outer surface of the electrode layer 370_1 may include, on the outer surface thereof, a first exposed surface 370S1 that is exposed without the insulating film 380_1 formed thereon and a second exposed surface 370S2 that is the other surface opposed to one surface in contact with a second semiconductor layer 320_1. The first exposed surface 370S1 and the second exposed surface 370S2, which are the exposed surfaces without the insulating film 380_1 formed thereon, may be exposed in the process of etching the insulating coating film 3800 during the manufacturing process of the light emitting element 300_1. In the case of the light emitting element 300 of FIG. 6, only the top surface of the electrode layer 370 is exposed in the process of etching the insulating coating film 3800. However, in the case of the light emitting element 300_1 of FIG. 20, the first exposed surface 370S1 of the electrode layer 370_1 may also be exposed. Meanwhile, as illustrated in the drawing, the side surfaces of the electrode layer 370_1 are not entirely but partially exposed, so that a partial region thereof may be in contact with the insulating film 380_1. That is, the side surface of the electrode layer 370_1 may include the region in contact with the insulating film 380_1 and the first exposed surface 370S1 that is exposed without the insulating film 380_1 formed thereon.

The insulating film 380_1 may include a first portion 380S1 and a second portion 380S2. The insulating film 380_1 may be formed to expose the first exposed surface 370S1 of the electrode layer 370_1, and the first portion 380S1 may be connected to the first exposed surface 370S1 and curved to have an inclined outer surface. That is, in accordance with one embodiment, the thickness of the first portion 380S1 of the insulating film 380_1 may decrease in one direction in which the light emitting element 300_1 extends. The second portion 380S2 may be connected to the first portion 380S1 to form a flat outer surface. The first portion 380S1 may be disposed to surround a part of the electrode layer 370_1 and the second semiconductor layer 320_1, and the second portion 380S2 may be disposed to surround an active layer 330_1 and a first semiconductor layer 310_1. However, the disclosure is not limited thereto, and the first portion 380S1 having the inclined outer surface may be disposed to surround a part of the active layer 330_1.

In the light emitting element 300_1 of the embodiment, the insulating film 380_1 may have portions having different thicknesses, e.g., the first portion 380S1 and the second portion 380S2. As described above, the insulating film 380_1 may have a thickness of a certain level or more to protect at least the active layer 330_1, and the second portion 380S2 of the insulating film 380_1, which is the portion surrounding the active layer 330_1, may have a thickness greater than that of the first portion 380S1 having the inclined outer surface.

In accordance with one embodiment, in the insulating film 380_1 of the light emitting element 300_1, a third thickness W3 that is the thickness of the second portion 380S2 surrounding the active layer 330_1 may be greater than the thickness of the first portion 380S1 having the inclined outer surface. Further, at the first portion 380S1, a first thickness W1 measured at the interface between the electrode layer 370_1 and the second semiconductor layer 320_1 and a second thickness W2 measured at the interface between the second semiconductor layer 320_1 and the active layer 330_1 may be different from each other. Due to the inclined outer surface, the first thickness W1 of the portion of the first portion 380S1 adjacent to the first exposed surface 370S1 of the electrode layer 370_1 that is exposed may be smaller than the second thickness W2 of the portion adjacent to the second portion 380S2, and the third thickness W3 may be greater than the first thickness W1 and the second thickness W2. In an embodiment, in the insulating film 380_1, the third thickness W3 of the second portion 380S2 may be within the range of 60 nm to 80 nm, and the first thickness W1 and the second thickness W2 of the first portion 380S1 having the inclined outer surface may be smaller than the third thickness W3. However, the disclosure is not limited thereto.

Such a shape of the light emitting element 300_1 may be formed by simultaneously etching the upper surface of the insulating film 380_1 at the time of etching the insulating coating film 3800 during the manufacturing process of the light emitting element 300_1.

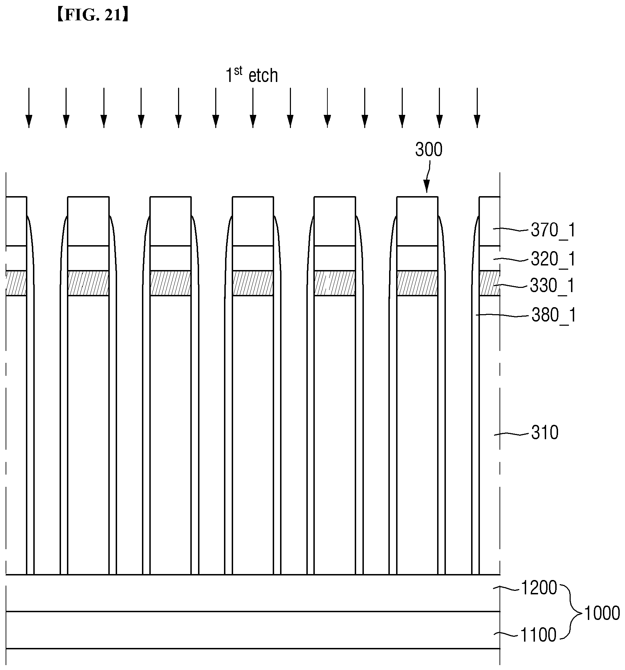

FIG. 21 is a cross-sectional view partially illustrating a manufacturing process of the light emitting element of FIG. 20.

Referring to FIG. 21, in the manufacturing process of the light emitting element 300_1, the insulating coating film 3800 may be partially removed to expose the top surface of the electrode layer 370_1. The process of partially removing the insulating coating film 3800 may be executed by a method of performing etching in a direction perpendicular to the lower substrate 1000. At this time, the side surface of the insulating coating film 3800 may be partially etched. In the light emitting element 300_1 thus formed, the insulating film 380_1 may be etched to form the first portion 380S1 having the inclined outer surface.

Meanwhile, as described above, the insulating film 380_1 of the light emitting element 300_1 may be partially etched and have a reduced thickness during the manufacturing process of the display device 10. In this case, the thickness relationship of the first thickness W1, the second thickness W2, and the third thickness W3 of the insulating film 380_1 may be changed.

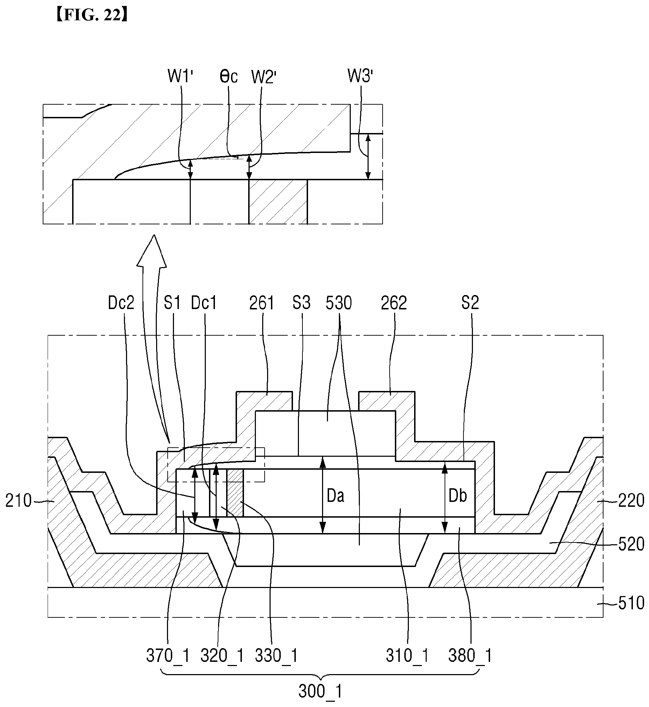

FIG. 22 is a cross-sectional view illustrating a part of the display device including the light emitting element of FIG. 20.

FIG. 22 illustrates a cross section passing through both ends of the light emitting element 300_1 of the display device 10 including the light emitting element 300_1 of FIG. 20. The embodiment is different from the embodiment of FIG. 7 in that the light emitting element 300 is the light emitting element 300_1 of FIG. 20. That is, in the embodiment of FIG. 22, the insulating film 380_1 of the light emitting element 300_1 includes the first portion 380S1 having the inclined outer surface, so that the shape of the first surface S1 where the first contact electrode 261 and the insulating film 380_1 are in contact with each other may be changed. In the following description, redundant description will be omitted while focusing on differences.

Referring to FIG. 22, the light emitting element 300_1 may include one side surface that is a lower surface and the other side surface that is an upper surface in cross-sectional view. The one side surface may be in contact with the second insulating layer 520 and the third insulating layer 530. In the light emitting element 300_1 according to one embodiment, the insulating film 380_1 includes the first portion 380S1 forming the inclined outer surface, and the electrode layer 370_1 includes the second exposed surface 370S2 that is exposed. Accordingly, one side surface of the light emitting element 300_1 may be partially spaced apart from the second insulating layer 520. As illustrated in the drawing, on the one side surface of the light emitting element 300_1, the first portion 380S1 of the insulating film 380_1 and the second exposed surface 370S2 of the electrode layer 370_1 may be spaced apart from the second insulating layer 520.

The other side surface of the light emitting element 300_1 may be in contact with the first contact electrode 261, the third insulating layer 530, and the second contact electrode 262. On the other side surface, except the first surface S1 in contact with the first contact electrode 261, the second surface S2 in contact with the second contact electrode 262 and the third surface S3 in contact with the third insulating layer 530 are substantially the same as those of the embodiment of FIG. 7. On the other hand, the first surface S1 may be positioned across the first portion 380S1 forming the inclined outer surface of the insulating film 380_1 and the second exposed surface 370S2 of the electrode layer 370_1 that is exposed. That is, in accordance with one embodiment, the first contact electrode 261 may be in contact with the second exposed surface 370S2 of the electrode layer 370_1 and the first portion 380S1 of the insulating film 380_1, and the first surface S1 may be formed to be partially inclined or curved.

Further, as described above, the display device 10 may include the region in which the thickness of the insulating film 380 of the light emitting element 300 is partially different. The insulating film 380_1 may have a smaller thickness in the region where the first surface S1 and the second surface S2 are positioned than in the region where the third surface S3 is positioned. In the light emitting element 300_1 of FIG. 20, the insulating film 380_1 may have the inclined outer surface at the first portion 380S1, and the first thickness W1 measured at the interface between the electrode layer 370_1 and the second semiconductor layer 320_1 may be smaller than the second thickness W2 measured at the interface between the second semiconductor layer 320_1 and the active layer 330_1.

During the manufacturing process of the display device 10, the first portion 380S1 of the insulating film 380_1 may be partially etched, so that a first thickness W1' and a second thickness W2' may be further reduced. On the other hand, in the insulating film 380_1, the region where the third surface S3 in contact with the third insulating layer 530 is positioned may not be etched, so that a third thickness W3' measured in this region may be maintained at a constant level. That is, the third thickness W3' may be greater than the first thickness W1' and the second thickness W2'. Further, due to the inclined outer surface of the first portion 380S1 of the insulating film 380_1 of the light emitting element 300_1, the first thickness W1' may be smaller than the second thickness W2'.

Accordingly, the light emitting element 300_1 may have different diameters depending on positions. For example, in the light emitting element 300_1, the first diameter Da that is the diameter measured in the other direction in the region where the third surface S3 is positioned may be greater than the second diameter Db measured in the region where the second surface S2 is positioned and the third diameter Dc measured in the region where the first surface S1 is positioned. Further, in the light emitting element 300_1, in the region where the first surface S1 is positioned, the third-first diameter Dc1 measured at the interface between the active layer 330_1 and the second semiconductor layer 320_1 may be greater than the third-second diameter Dc2 measured at the interface between the second semiconductor layer 320_1 and the electrode layer 370_1. However, the disclosure is not limited thereto.

Meanwhile, in accordance with one embodiment, at the first portion 380S1 of the insulating film 380_1, the first thickness W1' and the second thickness W2' may satisfy the following Eq. (1):

[Equation 1]

$$\theta c = \arctan((W2'\text{-}W1')/D) \leq 70°$$

where $\theta c$ is the inclination angle of the inclined outer surface of the insulating film 380_1, W1' is the thickness measured at the interface between the electrode layer 370_1 and the second semiconductor layer 320_1 in the insulating film 380_1, W2' is the thickness measured at the interface between the second semiconductor layer 320_1 and the active layer 330_1 in the insulating film 380_1, and D is the thickness of the second semiconductor layer 320_1.

As described above, the insulating film 380_1 of the light emitting element 300_1 has a thickness of a certain level or more to protect the active layer 330_1 and is disposed to surround at least the active layer 330_1. The light emitting element 300_1 disposed in the display device 10 may be disposed to cover the active layer 330_1 and protect it even if the insulating film 380_1 is partially etched. As illustrated in FIG. 22, in the light emitting element 300_1, the insulating film 380_1 may include the first portion 380S1 in which the inclined outer surface is formed, and the active layer 330_1 may be positioned to overlap the first portion 380S1 of the insulating film 380_1.

Here, in order to smoothly protect the active layer 330_1, the first portion 380S1 may have a minimum thickness in the region overlapping the active layer 330_1, and the inclination angle $\theta c$ of the inclined outer surface may be defined. Particularly, the inclination angle $\theta c$ of the first portion 380S1 may be measured with respect to the second semiconductor layer 320_1 so that the insulating film 380_1 may protect the active layer 330_1. In accordance with one embodiment, in the insulating film 380_1 of the light emitting element 300_1 of the display device 10, the inclination angle $\theta c$ of the first portion 380S1 may be 70° or less, and the second thickness W2' may be 40 nm or more. The insulating film 380_1 of the light emitting element 300_1 may have the thickness within the above-described range, and may have a thickness sufficient to protect the active layer 330_1 even if it is partially etched to form the first portion 380S1 having the inclined outer surface during the manufacturing process of the light emitting element 300_1. Particularly, in the light emitting element 300_1 disposed in the display device 10, the thickness (the second thickness W2') of the insulating film 380_1 surrounding the active layer 330_1 is within the range of 40 nm or more, and the inclination angle $\theta c$ is within the range of 70° or less with respect to the second semiconductor layer 320_1, so that the light emitting element 300_1 may prevent damage of the active layer 330_1. Accordingly, the display device 10 may include the light emitting element 300_1 and have improved luminous efficiency and luminous reliability.

Meanwhile, in the insulating film 380, the first thicknesses W1 and W1' measured at the interface between the second semiconductor layer 320 and the electrode layer 370 may be 0 nm or more. That is, in the light emitting element 300 according to one embodiment, the insulating film 380 may not be disposed at the interface between the electrode layer 370 and the second semiconductor layer 320.

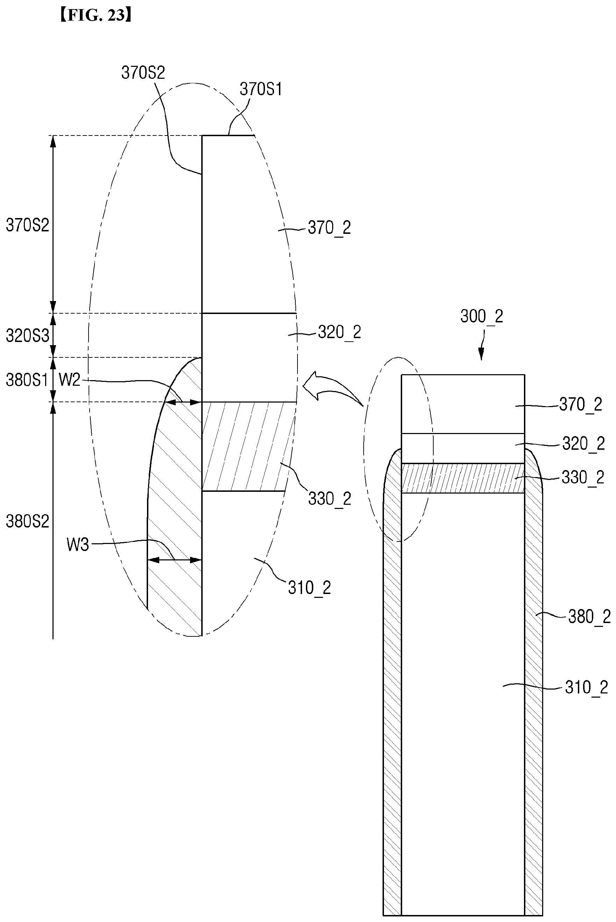

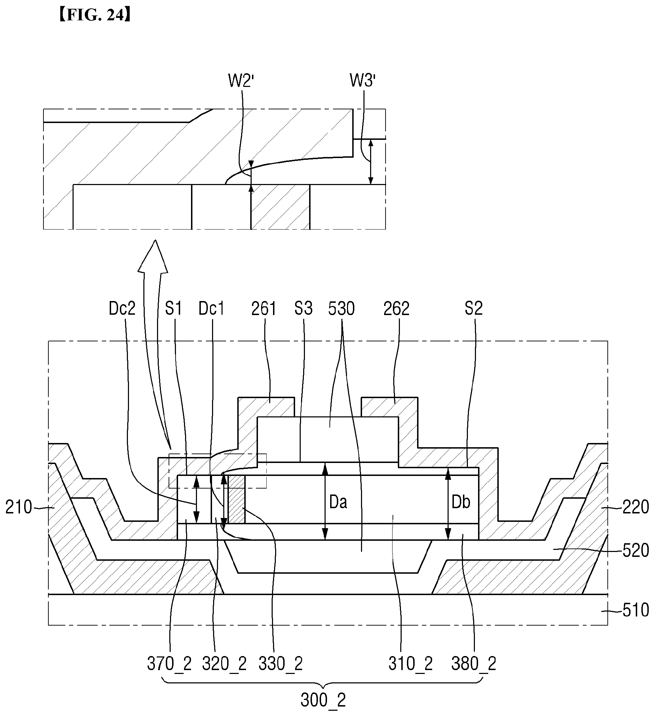

FIG. 23 is a schematic cross-sectional view of a light emitting element according to one embodiment. FIG. 24 is a cross-sectional view illustrating a part of the display device including the light emitting element of FIG. 23.

Referring to FIG. 23, in a light emitting element 300_2 according to one embodiment, all side surfaces of an electrode layer 370_2 may be exposed, and a side surface of a second semiconductor layer 320_2 may also be partially exposed. Accordingly, the electrode layer 370_2 may include the first exposed surface 370S1 and the second exposed surface 370S2, and the second semiconductor layer 320_2 may further include a third exposed surface 320S3. The insulating film 380_2 may include the first portion 380S1 connected to the third exposed surface 320S3 and having an inclined outer surface, and the second portion 380S2 connected to the first portion 380S1 and having a flat outer surface. The first portion 380S1 of the insulating film 380_2 may partially overlap only the second semiconductor layer 320_2 to partially expose the second semiconductor layer 320_2. The embodiment is different from the embodiment of FIG. 20 in that the side surface of the second semiconductor layer 320_2 is further exposed. In the insulating film 380_2 of the light emitting element 300_2, the second thickness W2 that is the thickness of the first portion 380S1 may be smaller than the third thickness W3 that is the thickness of the second portion 380S2, and the thickness measured at the interface between the electrode layer 370_2 and the second semiconductor layer 320_2 at the first portion 380S1 may be 0 nm. The other descriptions are the same as those described above with reference to the embodiment of FIG. 20, so that the detailed description thereof will be omitted.

Referring to FIG. 24, the light emitting element 300_2 may include one side surface that is a lower surface and the other side surface that is an upper surface in cross-sectional view. The one side surface may be in contact with the second insulating layer 520 and the third insulating layer 530. In the light emitting element 300_2 according to one embodiment, the electrode layer 370_2 may include the second exposed surface 370S2 that is exposed and the second semiconductor layer 320_2 may include the third exposed surface 320S3 that is partially exposed. Accordingly, one side surface of the light emitting element 300_2 may be partially spaced apart from the second insulating layer 520. As illustrated in the drawing, on the one side surface of the light emitting element 300_2, the first portion 380S1 of the insulating film 380_2, the second exposed surface 370S2 of the electrode layer 370_2, and the third exposed surface 320S3 of the second semiconductor layer 320_2 may be spaced apart from the second insulating layer 520.

The other side surface of the light emitting element 300_2 may be in contact with the first contact electrode 261, the third insulating layer 530, and the second contact electrode 262. On the other side surface, except the first surface S1 in contact with the first contact electrode 261, the second surface S2 in contact with the second contact electrode 262 and the third surface S3 in contact with the third insulating layer 530 are substantially the same as those of the embodiment of FIG. 20. On the other hand, the first surface S1 may be positioned across the first portion 380S1 forming the inclined outer surface of the insulating film 380_2, the second exposed surface 370S2 of the electrode layer 370_2 that is exposed, and the third exposed surface 320S3 of the second semiconductor layer 320_2 that is exposed. That is, in accordance with one embodiment, the first contact electrode 261 may be in contact with the third exposed surface 320S3 of the second semiconductor layer 320_2, the second exposed surface 370S2 of the electrode layer 370_2, and the first portion 380S1 of the insulating film 380_2, and the first surface S1 may be partially inclined or curved.

Further, in the light emitting element 300_2 of FIG. 23, the insulating film 380_2 has the inclined outer surface at the first portion 380S1 and the second semiconductor layer 320_2 is partially exposed, so that the insulating film 380_2 is not disposed at the interface between the second semiconductor layer 320_2 and the electrode layer 370_2, and the second thickness W2 of the insulating film 380_2 may be defined at the interface between the second semiconductor layer 320_2 and the active layer 330_2.

During the manufacturing process of the display device 10, the first portion 380S1 of the insulating film 380_2 is partially etched, so that the second thickness W2' may be further reduced. On the other hand, in the insulating film 380_2, the region where the third surface S3 in contact with the third insulating layer 530 is positioned is not etched, so that the third thickness W3' that is the thickness measured in this region may be maintained at a constant level. That is, the third thickness W3' may be greater than the second thickness W2'. However, the second thickness W2' may be within the range of at least 40 nm in order to protect the active layer 330_2 of the light emitting element 300_2. Accordingly, the light emitting element 300_2 may prevent damage of the active layer 330_2, and the display device 10 may have improved luminous efficiency and luminous reliability.

Meanwhile, according to some embodiments, the first electrode 210 and the second electrode 220 may not have the electrode stems 210S and 220S extending in the first direction DR1.

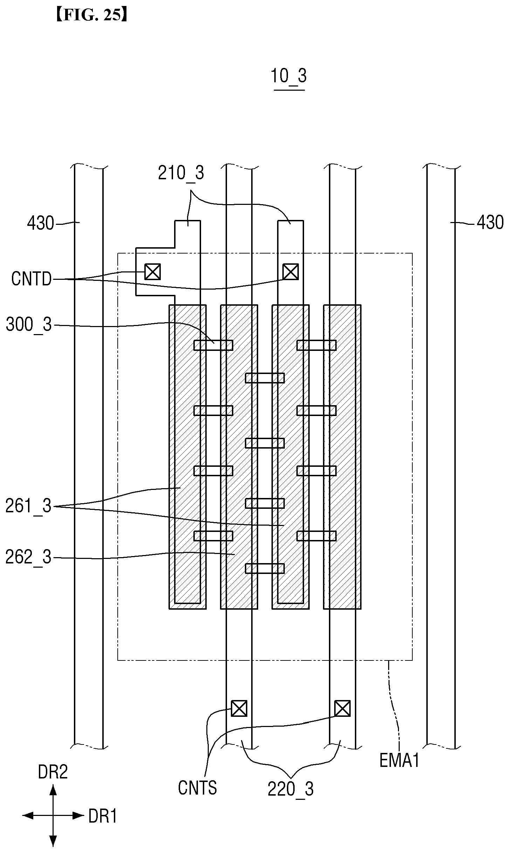

FIG. 25 is a plan view illustrating one sub-pixel of a display device according to one embodiment.

Referring to FIG. 25, in a display device 10_3, a first electrode 210_3 and a second electrode 220_3 may extend in one direction, i.e., in the second direction DR2. The first electrode 210_3 and the second electrode 220_3 may not have the electrode stems 210S and 220S extending in the first direction DR1. The display device 10_3 of FIG. 25 is different from the display device 10 of FIG. 3 in that the electrode stems 210S and 220S are omitted and one second electrode 220_3 is further included. In the following description, redundant description will be omitted while focusing on differences.

As shown in FIG. 25, the plurality of first electrodes 210_3 and second electrodes 220_3 may extend in the second direction DR2 in each sub-pixel PXn. The external bank 430 may also extend in the second direction DR2. The second electrode 220_3 and the external bank 430 may extend to another sub-pixel PXn adjacent in the second direction DR2. Accordingly, each of the sub-pixels PXn adjacent in the second direction DR2 may receive the same electrical signal from the second electrode 220_3.

Unlike the display device 10 of FIG. 3, in the display device 10_3 of FIG. 25, the second electrode contact hole CNTS may be disposed in each second electrode 220_3. The second electrode 220_3 may be electrically connected to the power electrode 162 of the circuit element layer PAL through the second electrode contact hole CNTS disposed in each sub-pixel PXn. Although it is illustrated in the drawing that the second electrode contact hole CNTS is formed in each of the two second electrodes 220_3, the disclosure is not limited thereto.

On the other hand, the first electrode 210_3 may extend in the second direction DR2 to be terminated at the boundary of each sub-pixel PXn. Each of the sub-pixels PXn adjacent in the second direction DR2 may include the first electrodes 210_3 spaced apart from each other, and they may receive different electrical signals through the first electrode contact holes CNTD. The first electrode 210_3 may have a shape extending in the second direction DR2 and terminated at the boundary between adjacent sub-pixels PXn during the manufacturing process of the display device 10. In the embodiment of FIG. 25, the light emitting elements 300 between one first electrode 210_3 and one second electrode 220_3 and the light emitting elements 300 between the other first electrode 210_3 and the other second electrode 220_3 may be connected in parallel.

Meanwhile, in the display device 10_3 of FIG. 25, some electrodes 210_3 and 220_3 may disposed as floating electrodes without being electrically connected to the circuit element layer PAL through the electrode contact holes CNTD and CNTS. For example, among the plurality of electrodes 210_3 and 220_3, only the electrodes positioned at the outer part may receive the electrical signals through the electrode contact holes CNTD and CNTS, and the electrodes 210_3 and 220_3 disposed therebetween may not receive electrical signals directly. In this case, a part of the second electrodes 220_3, e.g., the second electrode 220_3 disposed between different first electrodes 210_3, may extend in the second direction DR2 and be terminated at the boundary of each sub-pixel PXn without being disposed in another sub-pixel PXn, similarly to the first electrode 210_3. When some of the plurality of electrodes 210_3 and 220_3 are floating electrodes, the light emitting elements 300 disposed therebetween may be partially connected in series as well as in parallel. The external bank 430 may be disposed at the boundary of the sub-pixels PXn adjacent in the first direction DR1 and may extend in the second direction DR2. Although not shown in the drawing, the external bank 430 may be disposed at the boundary between the sub-pixels PXn adjacent in the second direction DR2 and may extend in the first direction DR1. The description of the external bank 430 is the same as the above description with reference to FIG. 3. Further, the first contact electrode 261_3 and the second contact electrode 262_3 included in the display device 10_3 of FIG. 25 are substantially the same as those of the display device 10 of FIG. 3.

FIG. 25 illustrates that two first electrodes 210_3 and two second electrodes 220_3 are disposed and alternately spaced apart from each other. However, the disclosure is not limited thereto, and some electrodes may be omitted or a larger number of electrodes may be disposed in the display device 10_3.

Meanwhile, the first electrode 210 and the second electrode 220 of the display device 10 may not necessarily have the shape extending in one direction. The shapes of the first electrode 210 and the second electrode 220 of the display device 10 may not be particularly limited as long as they are placed apart from each other to provide therebetween the space in which the light emitting elements 300 are disposed.

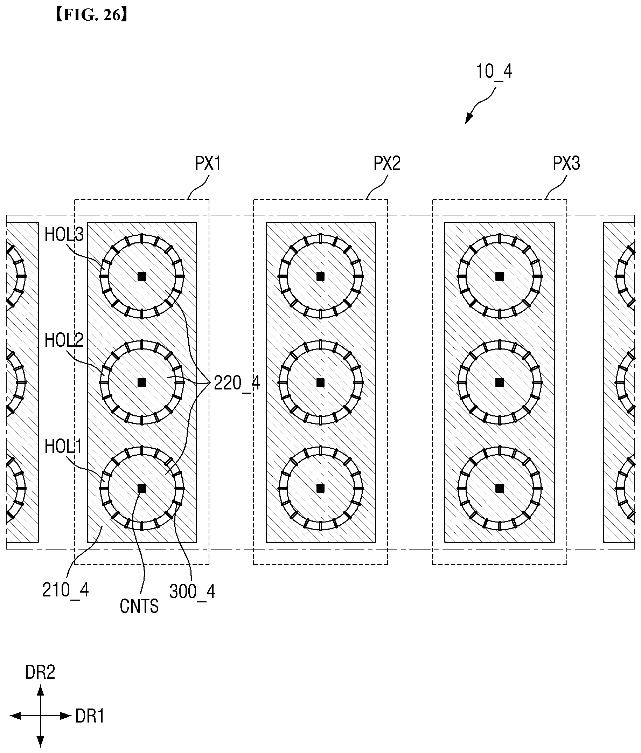

FIG. 26 is a plan view illustrating one pixel of a display device according to one embodiment.

Referring to FIG. 26, at least some areas of a first electrode 210_4 and a second electrode 220_4 of a display device 10_4 according to the embodiment have curved shapes, and the curved area of the first electrode 210_4 may face the curved area of the second electrode 220_4 while being spaced apart from each other. The display device 10_4 of FIG. 26 differs from the display device 10 of FIG. 2 in that the shapes of the first and second electrodes 210_4 and 220_4 are different from those of the display device 10. In the following description, redundant description will be omitted while focusing on differences.

The first electrode 210_4 of the display device 10_4 of FIG. 26 may include multiple holes HOL. For example, as illustrated in the drawing, the first electrode 210_4 may include a first hole HOL1, a second hole HOL2, and a third hole HOL3 arranged in the second direction DR2. However, the embodiment is not limited to thereto, and the first electrode 210_4 may include a larger number of holes HOL, a smaller number of holes HOL, or even a single hole HOL. Below, the description will be provided for an example where the first electrode 210_4 includes the first hole HOL1, the second hole HOL2, and the third hole HOL3.

In an embodiment, the first hole HOL1, the second hole HOL2, and the third hole HOL3 may have a circular shape in plan view. Accordingly, the first electrode 210_4 may have curved areas formed by the holes HOL, and face the second electrodes 220_4 in these curved areas. However, this is merely illustrative, and the disclosure is not limited thereto. The first hole HOL1, the second hole HOL2, and the third hole HOL3 are not particularly limited in shape as long as they can provide spaces for accommodating the second electrodes 220_4 therein. By way of example, the holes may have elliptical shapes, polygonal shapes such as rectangles, or the like in plan view.

The second electrode 220_4 may be plural in number, and the plurality of second electrodes 220_4 may be disposed in each sub-pixel PXn. By way of example, in each sub-pixel PXn, three second electrodes 220_4 may be disposed in each sub-pixel PXn to correspond to the first to third holes HOL1, HOL2, and HOL3 of the first electrode 210_4. The second electrodes 220_4 may be respectively disposed within the first to third holes HOL1, HOL2, and HOL3, surrounded by the first electrode 210_4.

In an embodiment, the holes HOL of the first electrode 210_4 may have curved surfaces, and each second electrode 220_4 placed in the corresponding hole HOL of the first electrode 210_4 may also have a curved surface and be disposed to face the first electrode 210_4 with a gap therebetween. As illustrated in FIG. 26, the first electrode 210_4 may include the holes HOL having circular shapes in plan view, and the second electrodes 220_4 may have circular shapes in plan view. The curved surface of the area of the first electrode 210_4 where each hole HOL is formed may face the curved outer surface of the corresponding one of the second electrodes 220_4 with a gap therebetween. For example, the first electrode 210_4 may be disposed to surround the outer surfaces of the second electrodes 220_4.

As stated above, light emitting elements 300 may be disposed between the first electrode 210_4 and the second electrode 220_4. The display device 10_4 according to the embodiment may include the second electrode 220_4 having the circular shape and the first electrode 210_4 disposed to surround it, and the multiple light emitting elements 300 may be arranged along the curved outer surface of the second electrode 220_4. As stated above, since the light emitting elements 300 have the shapes extending in one direction, the light emitting elements 300 arranged along the curved outer surface of the second electrode 220_4 in each sub-pixel PXn may be disposed such that their extension directions are directed in different directions. Each sub-pixel PXn may have many different light emission directions depending on the directions in which the extension directions of the light emitting elements 300 are directed. In the display device 10_4 according to the embodiment, by disposing the first and second electrodes 210_4 and 220_4 to have the curved shapes, the light emitting elements 300 disposed between them may be oriented toward different directions, and lateral visibility of the display device 10_4 can be improved.

In concluding the detailed description, those skilled in the art will appreciate that many variations and modifications can be made to the preferred embodiments without substantially departing from the scope of the invention as defined by the claims. Therefore, the disclosed preferred embodiments of the invention are used in a generic and descriptive sense only and not for purposes of limitation.

**Claims**

1. A light emitting element (300, 300_1, 300_2) comprising:

    a first semiconductor layer (310, 310_1, 310_2) doped with a first polarity;

a second semiconductor (320, 320_1, 320_2) layer doped with a second polarity different from the first polarity;

an active layer (330, 300_1, 330_2) disposed between the first semiconductor layer and the second semiconductor layer; and

an insulating film (380, 380_1, 380_2) disposed to surround at least an outer surface of the active layer and extending in a first direction in which the first semiconductor layer, the active layer, and the second semiconductor layer are stacked,

**characterised in that**

a thickness of a first portion (380S2) of the insulating film surrounding the active layer is in a range of 10% to 16% of a diameter of the active layer.

2. The light emitting element (300, 300_1, 300_2) of claim 1, wherein the diameter of the active layer (330, 330_1, 330_2) is in a range of 500 nm to 600 nm, and the thickness of the first portion (380S2) of the insulating film is in a range of 60 nm to 80 nm.

3. The light emitting element (300_1, 300_2) of claim 2, wherein the insulating film (380_1, 380_2) further includes a second portion (380S1) connected to the first portion (380S2) and disposed to cover a partial region of a side surface of the second semiconductor layer (320_1, 320_2), and a thickness of the second portion is smaller than a thickness of the first portion.

4. The light emitting element (300_1, 300_2) of claim 3, wherein in the insulating film (380_1, 380_2), a portion surrounding an interface between the active layer (330_1, 330_2) and the second semiconductor (320_1, 320_2) layer has a thickness of at least 20 nm, optionally wherein the second portion (320S1) has a curved outer surface such that its thickness decreases in the first direction.

5. The light emitting element (300, 300_1, 300_2) of any one of claims 1 to 4, further comprising an electrode layer (370, 370_1, 370_2) disposed on the second semiconductor layer (320, 320_1, 320_2),

wherein a thickness of the electrode layer is greater than a thickness of the second semiconductor layer, optionally wherein the electrode layer has a thickness in a range of 20 nm to 200 nm.

6. The light emitting element (300, 300_1) of claim 5, wherein:

(i) the insulating film (380) is disposed to surround a side surface of the electrode layer (370); and/or

(ii) the insulating film (380_1) is disposed to surround a part of a side surface of the electrode layer (370_1), and the electrode layer has a top surface and a side surface partially exposed.

7. The light emitting element (300_1) of claim 6, wherein the insulating film (380_1) further includes a third portion connected to the first portion (380S2) and surrounding a partial region of the side surface of the electrode layer (370_1), and a thickness of the third portion is smaller than a thickness of the first portion, optionally wherein the third portion has a curved outer surface such that its thickness decreases in the first direction.

8. A display device (10, 10_1, 10_2, 10_3, 10_4) comprising:

a substrate (1100);

a first electrode (210) disposed on the substrate and a second electrode (220) spaced apart from the first electrode;

at least one light emitting element (300, 300_1, 300_2) disposed between the first electrode and the second electrode and electrically connected to the first electrode and the second electrode;

a first insulating layer (520) disposed under the light emitting element between the first electrode and the second electrode; and

a second insulating layer (530) disposed on the light emitting element and exposing one end and the other end of the light emitting element,

wherein the light emitting element includes:

a first semiconductor layer (310, 310_1, 310_2) doped with a first polarity;

a second semiconductor layer (320, 320_1, 320_2) doped with a second polarity different from the first polarity;

an active layer (330, 330_1, 330_2) disposed between the first semiconductor layer and the second semiconductor layer; and

an insulating film (380, 380_1, 380_2) disposed to surround at least an outer surface of the active layer and extending in a first direction in which the first semiconductor layer, the active layer, and the second semiconductor layer are stacked,

wherein the insulating film includes a second portion in contact with the second insulating layer, a first portion surrounding one end of the light emitting element including the active layer, and a third portion surrounding the other end of the light emitting element, and

**characterised in that**

a thickness of the second portion is greater than that of the first portion and the third portion.

9. The display device (10, 10_1, 10_2, 10_3, 10_4) of claim 8, further comprising a first contact electrode (261) in contact with the first electrode (210) and the one end of the light emitting element (300, 300_1, 300_2) and a second contact electrode (262) in contact with the second electrode (220) and the other end of the light emitting element.

10. The display device (10, 10_1, 10_2, 10_3, 10_4) of claim 9, wherein the light emitting element further (300, 300_1, 300_2) includes an electrode layer (370, 370_1, 370_2) disposed on the second semiconductor layer (320, 320_1, 320_2) and having a thickness greater than that of the second semiconductor layer, the first contact electrode (261) being in contact with the first portion of the insulating film (380, 380_1, 380_2) and the electrode layer, the second contact electrode (262) being in contact with the third portion of the insulating film and the first semiconductor layer (310, 310_1, 310_2).

11. The display device (10, 10_1, 10_2, 10_3, 10_4) of claim 10, wherein the first portion of the insulating film (380_1) is disposed to surround a part of a side surface of the electrode layer (370_1), and the electrode layer has a top surface and a side surface partially exposed, optionally wherein the first contact electrode (261) is in contact with a part of a side surface and a top surface of the electrode layer.

12. The display device (10, 10_1, 10_2, 10_3, 10_4) of claim 10 or claim 11, wherein the first portion of the insulating film (380_1, 380_2) has a curved outer surface such that its thickness decreases in the first direction.

13. The display device (10, 10_1, 10_2, 10_3, 10_4) of claim 12, wherein in the first portion, a first thickness measured at an interface between the second semiconductor layer (320_1) and the electrode layer (370_1) and a second thickness measured at an interface between the second semiconductor layer and the active layer (330_1) satisfy the following Eq. (1):

[Equation 1]

$$\theta c = \arctan((W2'-W1')/D) \leq 70°$$

where θc is an inclination angle of an inclined outer surface of the first portion of the insulating film, W1' is a thickness measured at an interface between the electrode layer and the second semiconductor layer in the first portion of the insulating film, W2' is a thickness measured at an interface between the second semiconductor layer and the active layer in the first portion of the insulating film, and D is a thickness of the second semiconductor layer, optionally wherein the second thickness is 20 nm or more, and in the first portion, a thickness of a portion surrounding the active layer is 40 nm or more.

14. The display device (10, 10_1, 10_2, 10_3, 10_4) of any one of claims 10 to 13, wherein the electrode layer (370, 370_1, 370_2) has a thickness in a range of 20 nm to 200 nm.

15. The display device (10, 10_1, 10_2, 10_3, 10_4) of any one of claims 8 to 14, wherein a thickness of the second portion is in a range of 10% to 16% of a diameter of the active layer (330, 330_1, 330_2), optionally wherein the diameter of the active layer is in a range of 500 nm to 600 nm, and the thickness of the second portion of the insulating film is in a range of 60 nm to 80 nm, further optionally wherein in the light emitting element (300, 300_1, 300_2), a first diameter (Da) measured at the second portion of the insulating film (380, 380_1, 380_2) is greater than a second diameter (Dc) measured at the first portion of the insulating film and a third diameter (Db) measured at a third portion of the insulating film.

**Patentansprüche**

1. Licht emittierendes Element (300, 300_1, 300_2), das Folgendes umfasst:

   eine erste Halbleiterschicht (310, 310_1, 310_2), die mit einer ersten Polarität dotiert ist;
   eine zweite Halbleiterschicht (320, 320_1, 320_2), die mit einer zweiten Polarität dotiert ist, die sich von der ersten Polarität unterscheidet;
   eine aktive Schicht (330, 300_1, 330_2), die zwischen der ersten und der zweiten Halbleiterschicht angeordnet ist; und
   einen Isolierfilm (380, 380_1, 380_2), der dazu angeordnet ist, mindestens eine äußere Oberfläche der aktiven Schicht zu umgeben und sich in einer ersten Richtung zu erstrecken, in der die erste Halbleiterschicht, die aktive Schicht und die zweite Halbleiterschicht gestapelt sind,
   **dadurch gekennzeichnet, dass**
   die Dicke eines ersten Abschnitts (380S2) des die aktive Schicht umgebenden Isolierfilms in einem Bereich von 10 % bis 16 % des Durchmessers der aktiven Schicht liegt.

2. Licht emittierendes Element (300, 300_1, 300_2) nach Anspruch 1, wobei der Durchmesser der aktiven Schicht (330, 330_1, 330_2) in einem Bereich von 500 nm bis 600 nm liegt, und die Dicke des ersten Abschnitts (380S2) des Isolierfilms in einem Bereich von 60 nm bis 80 nm liegt.

3. Licht emittierendes Element (300_1, 300_2) nach Anspruch 2, wobei der Isolierfilm (380_1, 380_2) weiter einen zweiten Abschnitt (380S1) beinhaltet, der mit dem ersten Abschnitt (380S2) verbunden ist und dazu angeordnet ist, einen Teilbereich einer Seitenoberfläche der zweiten Halbleiterschicht (320_1, 320_2) zu bedecken, und eine Dicke des zweiten Abschnitts kleiner als eine Dicke des ersten Abschnitts ist.

4. Licht emittierendes Element (300_1, 300_2) nach Anspruch 3, wobei in der Isolierfolie (380_1, 380_2), ein Abschnitt, der eine Schnittstelle zwischen der aktiven Schicht (330_1, 330_2) und der zweiten Halbleiterschicht (320_1, 320_2) umgibt, eine Dicke von mindestens 20 nm aufweist, wobei der zweite Abschnitt (320S1) optional eine gekrümmte äußere Oberfläche derart aufweist, dass seine Dicke in der ersten Richtung abnimmt.

5. Licht emittierendes Element (300, 300_1, 300_2) nach einem der Ansprüche 1 bis 4, das weiter eine Elektrodenschicht (370, 370_1, 370_2) umfasst, die auf der zweiten Halbleiterschicht (320, 320_1, 320_2) angeordnet ist, wobei eine Dicke der Elektrodenschicht größer ist als eine Dicke der zweiten Halbleiterschicht, wobei die Elektrodenschicht optional eine Dicke in einem Bereich von 20 nm bis 200 nm aufweist.

6. Licht emittierendes Element (300, 300_1) nach Anspruch 5, wobei:

    (i) der Isolierfilm (380) dazu angeordnet ist, eine Seitenoberfläche der Elektrodenschicht (370) zu umgeben; und/oder
    (ii) der Isolierfilm (380_1) dazu angeordnet ist, einen Teil der Seitenoberfläche der Elektrodenschicht (370_1) zu umgeben, und die Elektrodenschicht eine Oberseite und eine Seitenoberfläche aufweist, die teilweise freigelegt sind.

7. Licht emittierendes Element (300_1) nach Anspruch 6, wobei der Isolierfilm (380_1) weiter einen dritten Abschnitt beinhaltet, der mit dem ersten Abschnitt (380S2) verbunden ist und einen Teilbereich der Seitenoberfläche der Elektrodenschicht (370_1) umgibt, und eine Dicke des dritten Abschnitts kleiner ist als eine Dicke des ersten Abschnitts ist, wobei der dritte Abschnitt optional eine gekrümmte Außenfläche derart aufweist, dass seine Dicke in der ersten Richtung abnimmt.

8. Anzeigevorrichtung (10, 10_1, 10_2, 10_3, 10_4), die Folgendes umfasst:

    ein Substrat (1100);
    eine erste Elektrode (210), die auf dem Substrat angeordnet ist, und eine zweite Elektrode (220), die von der ersten Elektrode beabstandet ist;
    mindestens ein Licht emittierendes Element (300, 300_1, 300_2), das zwischen der ersten und der zweiten Elektrode angeordnet und elektrisch mit der ersten und der zweiten Elektrode verbunden ist;
    eine erste Isolierschicht (520), die unter dem Licht emittierenden Element zwischen der ersten Elektrode und der zweiten Elektrode angeordnet ist; und
    eine zweite Isolierschicht (530), die auf dem Licht emittierenden Element angeordnet ist und ein Ende und das andere Ende des Licht emittierenden Elements freilegt,
    wobei das Licht emittierende Element Folgendes beinhaltet:

        eine erste Halbleiterschicht (310, 310_1, 310_2), die mit einer ersten Polarität dotiert ist;
        eine zweite Halbleiterschicht (320, 320_1, 320_2), die mit einer zweiten Polarität, die sich von der ersten Polarität unterscheidet, dotiert ist;
        eine aktive Schicht (330, 330_1, 330_2), die zwischen der ersten und der zweiten Halbleiterschicht angeordnet ist; und
        einen Isolierfilm (380, 380_1, 380_2), der dazu angeordnet ist, mindestens eine äußere Oberfläche der aktiven Schicht zu umgeben und sich in einer ersten Richtung zu erstrecken, in der die erste Halbleiterschicht, die aktive Schicht und die zweite Halbleiterschicht gestapelt sind,
        wobei der Isolierfilm einen zweiten Abschnitt beinhaltet, der mit der zweiten Isolierschicht in Kontakt steht, einen ersten Abschnitt, der ein Ende des Licht emittierenden Elements einschließlich der aktiven Schicht umgibt, und einen dritten Abschnitt, der das andere Ende des Licht emittierendes Elements umgibt, und
        **dadurch gekennzeichnet, dass**
        die Dicke des zweiten Abschnitts größer als die des ersten und des dritten Abschnitts ist.

9. Anzeigevorrichtung (10, 10_1, 10_2, 10_3, 10_4) nach Anspruch 8, die weiter eine erste Kontaktelektrode (261), die mit der ersten Elektrode (210) und dem einen Ende des Licht emittierendes Elements (300, 300_1, 300_2) in Kontakt steht, und eine zweite Kontaktelektrode (262), die mit der zweiten Elektrode (220) und dem anderen Ende des Licht emittierendes Elements in Kontakt steht, umfasst.

10. Anzeigevorrichtung (10, 10_1, 10_2, 10_3, 10_4) nach Anspruch 9, wobei das Licht emittierende Element (300, 300_1, 300_2) weiter eine Elektrodenschicht (370, 370_1, 370_2) beinhaltet, die auf der zweiten Halbleiterschicht (320, 320_1, 320_2) angeordnet ist und eine Dicke aufweist, die größer ist als die der zweiten Halbleiterschicht, wobei die erste Kontaktelektrode (261) mit dem ersten Abschnitt des Isolierfilms (380, 380_1, 380_2) und der Elektrodenschicht in Kontakt steht, wobei die zweite Kontaktelektrode (262) mit dem dritten Abschnitt des Isolierfilms und der ersten Halbleiterschicht (310, 310_1, 310_2) in Kontakt steht.

11. Anzeigevorrichtung (10, 10_1, 10_2, 10_3, 10_4) nach Anspruch 10, wobei der erste Teil des Isolierfilms (380_1) dazu angeordnet ist, einen Teil der Seitenoberfläche der Elektrodenschicht (370_1) zu umgeben, und die Elektrodenschicht eine Oberseite und eine Seitenoberfläche aufweist, die teilweise freigelegt sind, wobei die erste Kontaktelektrode (261) optional mit einem Teil Seitenoberfläche und einer Oberfläche der Elektrodenschicht in Kontakt steht.

12. Anzeigevorrichtung (10, 10_1, 10_2,10_3, 10_4) nach Anspruch 10 oder Anspruch 11, wobei der erste Abschnitt des Isolierfilms (380_1, 380_2) eine gekrümmte Außenfläche derart aufweist, dass seine Dicke in der ersten Richtung abnimmt.

13. Anzeigevorrichtung (10, 10_1,10_2, 10_3, 10_4) nach Anspruch 12, wobei in dem ersten Abschnitt eine erste Dicke an einer Grenzfläche zwischen der zweiten Halbleiterschicht (320_1) und der Elektrodenschicht (370_1) gemessen, und eine zweite Dicke, an einer Grenzfläche zwischen der zweiten Halbleiterschicht und der aktiven Schicht (330_1) gemessen die folgende Gleichung (1) erfüllt:

[Gleichung 1]

$$\theta c = \arctan((W2'-W1')/D) \le 70°$$

wobei θc ein Neigungswinkel einer geneigten äußeren Oberfläche des ersten Abschnitts des Isolierfilms ist, W1' eine Dicke an einer Grenzfläche zwischen der Elektrodenschicht und der zweiten Halbleiterschicht in dem ersten Abschnitt des Isolierfilms gemessen ist, W2' eine Dicke an einer Grenzfläche zwischen der zweiten Halbleiterschicht und der aktiven Schicht in dem ersten Abschnitt des Isolierfilms gemessen ist, und D eine Dicke der zweiten Halbleiterschicht ist, wobei die zweite Dicke optional 20 nm oder mehr beträgt, und in dem ersten Abschnitt eine Dicke eines die aktive Schicht umgebenden Abschnitts 40 nm oder mehr beträgt.

14. Anzeigevorrichtung (10, 10_1, 10_2, 10_3, 10_4) nach einem der Ansprüche 10 bis 13, wobei die Elektrodenschicht (370, 370_1, 370_2) eine Dicke in einem Bereich von 20 nm bis 200 nm aufweist.

15. Anzeigevorrichtung (10, 10_1, 10_2, 10_3, 10_4) nach einem der Ansprüche 8 bis 14, wobei eine Dicke des zweiten Abschnitts in dem Bereich von 10 % bis 16 % des Durchmessers der aktiven Schicht (330, 330_1, 330_2) liegt, wobei der Durchmesser optional der aktiven Schicht in einem Bereich von 500 nm bis 600 nm liegt und die Dicke des zweiten Abschnitts des Isolierfilms in einem Bereich von 60 nm bis 80 nm liegt, wobei weiter in dem Licht emittierenden Element (300, 300_1, 300_2) ein erster Durchmesser (Da), gemessen an dem zweiten Abschnitt des Isolierfilms (380, 380_1, 380_2), optional größer als ein zweiter Durchmesser (Dc), der an dem ersten Abschnitt das Isolierfilms gemessen wird, und ein dritter Durchmesser (Db), der an einem dritten Abschnitt der Isolierfolie gemessen wird, ist.

## Revendications

1. Élément électroluminescent (300, 300_1, 300_2) comprenant :

une première couche semi-conductrice (310, 310_1, 310_2) dopée avec une première polarité ;
un seconde couche semi-conductrice (320, 320_1, 320_2) dopée avec une seconde polarité différente de la première polarité ;
une couche active (330, 300_1, 330_2) disposée entre la première couche semi-conductrice et la seconde couche semi-conductrice ; et
un film isolant (380, 380_1, 380_2) disposé pour entourer au moins une surface extérieure de la couche active et s'étendant dans une première direction dans laquelle la première couche semi-conductrice, la couche active et la seconde couche semi-conductrice sont empilées,
**caractérisé en ce que**
l'épaisseur d'une première section (380S2) du film isolant entourant la couche active se situe dans une plage 10 % à 16 % du diamètre de la couche active.

2. Élément électroluminescent (300, 300_1, 300_2) selon la revendication 1, dans lequel le diamètre de la couche active (330, 330_1, 330_2) se situe dans une plage de 500 nm à 600 nm et l'épaisseur de la première section (380S2) du film isolant se situe dans une plage de 60 nm à 80 nm.

**3.** Élément électroluminescent (300_1, 300_2) selon la revendication 2, dans lequel le film isolant (380_1, 380_2) inclut en outre une deuxième section (380S1) reliée à la première section (380S2) et disposée pour recouvrir une région partielle d'une surface latérale de la seconde couche semi-conductrice (320_1, 320_2) et une épaisseur de la deuxième section est inférieure à une épaisseur de la première section.

**4.** Élément électroluminescent (300_1, 300_2) selon la revendication 3, dans lequel le film isolant (380_1, 380_2), une section entourant une interface entre la couche active (330_1, 330_2) et la seconde couche semi-conductrice (320_1, 320_2) présente une épaisseur d'au moins 20 nm, dans lequel la deuxième section (320S1) présente une surface extérieure incurvée de telle sorte que son épaisseur diminue dans la première direction.

**5.** Élément électroluminescent (300, 300_1, 300_2) selon l'une quelconque des revendications 1 à 4, comprenant en outre une couche d'électrode (370, 370_1, 370_2) disposée sur la seconde couche semi-conductrice (320, 320_1, 320_2), dans lequel une épaisseur de la couche d'électrode est supérieure à une épaisseur de la seconde couche semi-conductrice, facultativement dans lequel la couche d'électrode présente une épaisseur dans une plage de 20 nm à 200 nm.

**6.** Élément électroluminescent (300, 300_1) selon la revendication 5, dans lequel :

(i) le film isolant (380) est disposé pour entourer une surface latérale de la couche d'électrode (370) ; et/ou
(ii) le film isolant (380_1) est disposée pour entourer une section d'une surface latérale de la couche d'électrode (370_1) et la couche d'électrode présente une surface supérieure et une surface latérale partiellement exposées.

**7.** Élément électroluminescent (300_1) selon la revendication 6, dans lequel le film isolant (380_1) inclut en outre une troisième section reliée à la première section (380S2) et entourant une région partielle de la surface latérale de la couche d'électrode (370_1) et une épaisseur de la troisième section est inférieure à une épaisseur de la première section, facultativement dans lequel la troisième section présente une surface extérieure incurvée de telle sorte que son épaisseur diminue dans la première direction.

**8.** Dispositif d'affichage (10, 10_1, 10_2, 10_3, 10_4) comprenant :

un substrat (1100) ;
une première électrode (210) disposée sur le substrat et une seconde électrode (220) espacée de la première électrode ;
au moins un élément électroluminescent (300, 300_1, 300_2) disposée entre la première électrode et la seconde électrode et connectée électriquement à la première électrode et à la seconde électrode ;
une première couche isolante (520) disposée sous l'élément électroluminescent entre la première électrode et la seconde électrode ; et
une seconde couche isolante (530) disposée sur l'élément électroluminescent et exposant une extrémité et l'autre extrémité de l'élément électroluminescent,
dans lequel l'élément électroluminescent comprend :

une première couche semi-conductrice (310, 310_1, 310_2) dopée avec une première polarité ;
une seconde couche semi-conductrice (320, 320_1, 320_2) dopée avec une seconde polarité différente de la première polarité ;
une couche active (330, 330_1, 330_2) disposée entre la première couche semi-conductrice et la seconde couche semi-conductrice ; et
un film isolant (380, 380_1, 380_2) disposé pour entourer au moins une surface extérieure de la couche active et s'étendant dans une première direction dans laquelle la première couche semi-conductrice, la couche active et la seconde couche semi-conductrice sont empilées,
dans lequel le film isolant inclut une deuxième section en contact avec la seconde couche isolante, une première section entourant une extrémité de l'élément électroluminescent incluant la couche active et une troisième section entourant l'autre extrémité de l'élément électroluminescent, et **caractérisé en ce que**
une épaisseur de la deuxième section est supérieure à celle de la première section et de la troisième section.

**9.** Dispositif d'affichage (10, 10_1, 10_2, 10_3, 10_4) selon la revendication 8, comprenant en outre une première électrode de contact (261) en contact avec la première électrode (210) et l'une extrémité de l'élément électroluminescent (300, 300_1, 300_2) et une seconde électrode de contact (262) en contact avec la seconde électrode (220) et l'autre extrémité de l'élément électroluminescent.

**10.** Dispositif d'affichage (10, 10_1, 10_2, 10_3, 10_4) selon la revendication 9, dans lequel l'élément électroluminescent (300, 300_1, 300_2) inclut une couche d'électrode (370, 370_1, 370_2) disposée sur la seconde couche semi-conductrice (320, 320_1, 320_2) et présentant une épaisseur supérieure à celle de la seconde couche semi-conductrice, la première électrode de contact (261) étant en contact avec la première section du film isolant (380, 380_1, 380_2) et la couche d'électrode, la seconde électrode de contact (262) étant en contact avec la troisième section du film isolant et la première couche semi-conductrice (310, 310_1, 310_2).

**11.** Dispositif d'affichage (10, 10_1, 10_2, 10_3, 10_4) selon la revendication 10, dans lequel la première section du film isolant (380_1) est disposée pour entourer une partie d'une surface latérale de la couche d'électrode (370_1) et la couche d'électrode présente une surface supérieure et une surface latérale partiellement exposées, dans lequel la première électrode de contact (261) est en contact avec une partie d'une surface latérale et d'une surface supérieure de la couche d'électrode.

**12.** Dispositif d'affichage (10, 10_1, 10_2, 10_3, 10_4) selon la revendication 10 ou la revendication 11, dans lequel la première section du film isolant (380_1, 380_2) présente une surface extérieure incurvée de telle sorte que son épaisseur diminue dans la première direction.

**13.** Dispositif d'affichage (10, 10_1, 10_2, 10_3, 10_4) selon la revendication 12, dans lequel, dans la première section, une première épaisseur mesurée au niveau d'une interface entre la seconde couche semi-conductrice (320_1) et la couche d'électrode (370_1) et une seconde épaisseur mesurée au niveau d'une interface entre la seconde couche semi-conductrice et la couche active (330_1) satisfont à l'équation (1) suivante :

[Équation 1]

$$\theta c = \arctan((W2'-W1')/D) \leq 70°$$

où $\theta c$ est un angle d'inclinaison d'une surface extérieure inclinée de la première section du film isolant, W1' est une épaisseur mesurée au niveau d'une interface entre la couche d'électrode et la seconde couche semi-conductrice dans la première section du film isolant, W2' est une épaisseur mesurée au niveau d'une interface entre la seconde couche semi-conductrice et la couche active dans la première section du film isolant et D est une épaisseur de la seconde couche semi-conductrice, facultativement dans lequel la seconde épaisseur est de 20 nm ou plus et dans la première section, une épaisseur d'une section entourant la couche active est de 40 nm ou plus.

**14.** Dispositif d'affichage (10, 10_1, 10_2, 10_3, 10_4) selon l'une quelconque des revendications 10 à 13, dans laquelle la couche d'électrode (370, 370_1, 370_2) présente une épaisseur dans une plage de 20 nm à 200 nm.

**15.** Dispositif d'affichage (10, 10_1, 10_2, 10_3, 10_4) selon l'une quelconque des revendications 8 à 14, dans lequel l'épaisseur de la deuxième section se situe dans une plage de 10 % à 16 % d'un diamètre de la couche active (330, 330_1, 330_2), facultativement dans lequel le diamètre de la couche active se situe dans une plage de 500 nm à 600 nm et l'épaisseur de la deuxième section du film isolant se situe dans une plage de 60 nm à 80 nm, facultativement dans lequel dans l'élément électroluminescent (300, 300_1, 300_2), un premier diamètre (Da) mesuré au niveau de la seconde portion du film isolant (380, 380_1, 380_2) est supérieur à un deuxième diamètre (Dc) mesuré au niveau de la première section du film isolant et à un troisième diamètre (Db) mesuré au niveau d'une troisième section du film isolant.

【FIG. 1】

【FIG. 2】

【FIG. 3】

【FIG. 4】

【FIG. 5】

【FIG. 6】

【FIG. 7】

【FIG. 8】

【FIG. 9】

【FIG. 10】

【FIG. 11】

hole

3000'

370

320

330

310

1200
1000
1100

【FIG. 12】

1st etch

3800
370
320
330

310

1200
1000
1100

【FIG. 13】

ROD

380
370
320
330

310

1200
1100
1000

【FIG. 14】

【FIG. 15】

【FIG. 16】

【FIG. 17】

Xb
410        210  520  220        420  510        Xb'
300

【FIG. 18】

2nd etch

530'
300

Xb
410        210  520'  220        420  510        Xb'

【FIG. 19】

【FIG. 20】

【FIG. 21】

1st etch

300

370_1

320_1

330_1

380_1

310

1200
1100
1000

【FIG. 22】

【FIG. 23】

【FIG. 24】

【FIG. 25】

10_3

210_3

430

430

CNTD

300_3

261_3

262_3

DR2

DR1

CNTS

220_3

EMA1

【FIG. 26】

**EP 4 033 545 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018175106 A1